(19) Europäisches Patentamt
European Patent Office
Office européen des brevets

(11) **EP 0 806 079 B1**

(12) **EUROPEAN PATENT SPECIFICATION**

(45) Date of publication and mention of the grant of the patent:
**26.11.2003 Bulletin 2003/48**

(51) Int Cl.⁷: **H03D 1/00**, H04B 15/00, H04K 1/00, H04L 27/06, H04L 27/30, H04B 1/707

(21) Application number: **95932334.6**

(22) Date of filing: **25.08.1995**

(86) International application number:
**PCT/US95/10886**

(87) International publication number:
**WO 96/008077 (14.03.1996 Gazette 1996/12)**

(54) **TRANSMISSION AND RECEPTION OF CPM SPREAD-SPECTRUM COMMUNICATIONS**

ÜBERTRAGUNG UND EMPFANG VON KONTINUIERLICHEN,PHASENMODULIERTEN SPREIZBANDSIGNALEN

TRANSMISSION ET RECEPTION DE TELECOMMUNICATIONS A ETALEMENT DE SPECTRE ET A MODULATION A PHASE CONSTANTE

(84) Designated Contracting States:
**AT BE CH DE DK ES FR GB GR IE IT LI LU MC NL PT SE**

(30) Priority: **09.09.1994 US 304091**
**07.06.1995 US 484007**
**07.06.1995 US 481613**
**07.06.1995 US 486827**
**07.06.1995 US 476461**
**07.06.1995 US 480668**
**07.06.1995 US 486824**
**07.06.1995 US 480914**
**07.06.1995 US 480167**
**07.06.1995 US 486883**
**07.06.1995 US 480442**
**07.06.1995 US 480903**
**07.06.1995 US 480443**
**07.06.1995 US 485638**
**07.06.1995 US 477480**

(43) Date of publication of application:
**12.11.1997 Bulletin 1997/46**

(60) Divisional application:
**03007108.8 / 1 333 589**
**03007109.6 / 1 333 590**
**03007110.4 / 1 333 606**
**03007111.2 / 1 335 550**
**03007231.8 / 1 335 551**
**03007241.7 / 1 339 173**
**03018224.0**
**03018544.1**

(73) Proprietor: **XIRCOM Wireless, Inc.**
**Colorado Springs, Colorado 80907 (US)**

(72) Inventors:
• **DURRANT, Randolph, L.**
**Colorado Springs, CO 80920 (US)**
• **BURBACH, Mark, T.**
**Peyton, CO 80831 (US)**
• **HOYT, Eugene, P.**
**Colorado Springs, CO 80921 (US)**

(74) Representative: **Leeming, John Gerard**
**J.A. Kemp & Co.,**
**14 South Square,**
**Gray's Inn**
**London WC1R 5JJ (GB)**

(56) References cited:

| | |
|---|---|
| EP-A- 0 454 913 | EP-A- 0 501 829 |
| EP-A- 0 558 034 | EP-A- 0 565 506 |
| WO-A-92/17947 | JP-A- 4 360 494 |
| JP-A- 6 204 976 | US-A- 4 242 641 |
| US-A- 4 559 606 | US-A- 4 583 048 |
| US-A- 4 587 662 | US-A- 4 601 047 |
| US-A- 4 630 283 | US-A- 4 648 099 |
| US-A- 4 742 512 | US-A- 5 001 489 |
| US-A- 5 146 471 | US-A- 5 151 920 |
| US-A- 5 157 686 | US-A- 5 177 765 |
| US-A- 5 216 691 | US-A- 5 216 693 |
| US-A- 5 218 618 | US-A- 5 255 288 |
| US-A- 5 276 705 | US-A- 5 305 349 |
| US-A- 5 313 457 | US-A- 5 341 396 |
| US-A- 5 347 284 | US-A- 5 353 300 |

- DUPONTEIL ET AL: "ELEMENTS OF DIGITAL COMMUNICATION" 1992 , JOHN WILEY & SONS , CHICHESTER XP002089365 19136 * paragraph [2.3.3.2] * * paragraph [2.3.4.2] *
- J.B. ANDERSON et al., "Digital Phase Modulation", Published 1986, by PLENUM PRESS (NEW YORK), Chapters 6 and 7.
- ULTRASONICS, Volume 10, No. 2, March 1972, COLLINS et al., "The Role of Surface Acoustic Wave Technology in Communication Systems", pp. 59-71.
- IEEE TRANSACTIONS ON AEROSPACE AND ELECTRONIC SYSTEMS, Volume 24, No. 2, March 1988, TAYLOR Jr. et al., "Quadriphase Code- A Radar Pulse Compression Signal with Unique Characteristics", pp. 156-70.
- PROCEEDINGS OF THE 1980 IEEE NATIONAL TELECOMMUNICATIONS CONFERENCE, 30 November to 04 December 1980, SMITH, "SAW Filters for CPSM Spread Spectrum Communication", pp. 22.1.1-6.
- PROCEEDINGS OF THE SIXTH INTERNATIONAL CONFERENCE ON DIGITAL SATELLITE COMMUNICATIONS, 19-23 September 1983, NANAYAKKARA et al., "High Speed Receiver Designs Based on Surface Acoustic Wave Devices", pp. VI-16 to VI-22.
- IEEE CONFERENCE PROCEEDINGS, 1980, FRERET, "Wireless Terminal Communications Using Spread-Spectrum Radio", pp. 244-8.
- J.G. PROAKIS, "Digital Communications", Published 1989, by McGRAW-HILL, (NEW YORK), pp. 266-7.

## Description

Field of the Invention

The field of this invention relates to spread spectrum communication and, more particularly, to transmitting and receiving continuous phase modulated (CPM) signals such as spread spectrum signals.

Description of Related Art

Spread spectrum is a type of signal modulation that spreads a signal to be transmitted over a bandwidth that substantially exceeds the data-transfer rate, hence the term "spread spectrum". In direct sequence spread spectrum, a data signal is modulated with a pseudo-random chip sequence; the encoded spread spectrum signal is transmitted to the receiver which despreads the signal. Several techniques are available for the transmitter to modulate the data signal, including biphase shift keying (BPSK); and continuous phase modulated (CPM) techniques. Minimum shift keying (MSK) is a known variation of CPM.

In despreading a spread spectrum signal, the receiver produces a correlation pulse in response to the received spread spectrum signal when the received spread spectrum signal matches the chip sequence to a predetermined degree. Various techniques are available for correlating the received signal with the chip sequence, including those using surface acoustic wave (SAW) correlators, tapped delay line (TDL) correlators, serial correlators, and others.

In spread spectrum communication CPM techniques are often chosen so as to preserve signal bandwidth of the spread spectrum signal when it is amplified and transmitted. Using CPM techniques also has the advantage that "class C" amplifiers may be used for transmitting the spread spectrum signal. However, spread spectrum signals transmitted using CPM are difficult to decode with many types of spread spectrum correlators, including various SAW correlators and serial correlators. These types of correlators usually require a BPSK spread spectrum signal for effective correlation rather than an MSK or other CPM spread spectrum signal because a BPSK signal has either a zero or 180 degree phase shift for each chip time. Thus, each chip of a received BPSK signal may . be compared with each chip of the spread spectrum code, and a maximum correlation pulse may be generated when a predetermined number of matches occur. However, when a CPM signal with the same data signal and chip rate is applied to the same correlator, the correlation pulse will generally be very weak and may be quite difficult to detect.

Another problem often encountered in attempting to correlate spread spectrum signals transmitted using CPM techniques is the absence of a coherent reference signal in the receiver. A coherent reference signal in this sense may be defined as a locally generated signal that matches the transmitter carrier signal in frequency and phase. The receiver may use the locally generated reference signal to demodulate the received signal. In practice, however, it can be difficult to independently generate a local reference signal in the receiver precisely matching the transmitted carrier signal in frequency and phase. Rather, a local reference signal generated in the receiver will usually be of a non-coherent variety that is, having small differences in frequency and phase from the transmitter's carrier signal. These frequency and phase differences are not constant but vary over time. When an attempt is made to demodulate a received signal using a non-coherent reference signal, errors in correlation may occur due to mismatches in timing and variations in perceived amplitude caused by the frequency and phase differences.

Various methods for dealing with the above problem exist in which a coherent reference signal is created in the receiver by continuously measuring the frequency and phase differences between the received signal and a locally generated non-coherent reference signal, and then adjusting the non-coherent reference signal until it matches the frequency and phase of the received signal. Such methods, however, generally require the use of relatively complex feedback techniques and involve extra hardware. Moreover, locking onto the received frequency and phase can take an unacceptably large amount of time, particularly in systems where time is of the essence, such as in certain time division multiple access (TDMA) systems in which only a relatively brief time slot is allocated for periodic communication between a transmitter and receiver.

A particular non-coherent digital matched filter is described in A. Baier and P.W. Baier, "Digital Matched Filtering of Arbitrary Spread-Spectrum Waveforms Using Correlators with Binary Quantization, " 2 Proceedings, 1983 IEEE Military Communications Conference, Vol. 2, pp. 418-423 (1983). The digital filter described therein uses four real filter channels to perform four-phase quantization in the complex plane, with the four quadrants being the quantization regions, and the result taking on the four complex values of $\pm 1 \pm j$. In the described four-phase filter, an input signal is divided into an in-phase signal and a quadrature signal. The in-phase signal and the quadrature signal are separately filtered, sampled and digitized using 1-bit quantization. The quantized in-phase signal and the quantized quadrature signal are each fed into two binary correlators each programmed with a reference sequence of N chips, one chip for each sample . The outputs of the four binary correlators are combined to produce a resultant output signal. Baier's four-phase digital matched filter is also described in A. Baier, "A Low-Cost Digital Matched Filter for Arbitrary Constant-Envelope Spread Spectrum Waveforms," IEEE Transactions on Communications, Vol. Com-32, No. 4, April 1984, pp. 354-361.

These references suggest that for demodulation of non-coherent CPM signals such as QPSK, MSK, OQPSK, and GMSK signals, four real channels are needed to fully recover the transmitted signal. Further, the described four-phase filter shows only a system using 1-bit quantization, and does not describe a technique for serial correlation.

Accordingly, it would be advantageous to provide a method of modulation and demodulation particularly suited to CPM signals. It would further be advantageous to provide a method of CPM modulation and demodulation that does not require the generation of a coherent reference signal, that is capable of rapid correlation, and that may be used with analog correlators and digital correlators in an effective manner. It would further be advantageous to provide a flexible and effective system for CPM modulation and demodulation that does not require a coherent reference signal, and that is suitable for use in an environment of cellular communications.

The invention, which is defined in the appended claims, relates to a method and apparatus for receiving CPM spread spectrum signals using phase encoding to increase throughput. In one aspect of the invention, a preferred receiver receives a superposed spread spectrum signal, simultaneously attempts to correlate for a plurality of chip sequences (such as I and Q chip sequences), and interleaves the correlated data streams into a unified signal data stream.

In a second aspect of the invention, the receiver comprises a carrier signal that is neither frequency matched or phase matched with the transmitted signal. In this aspect, the receiver separates the received spread spectrum signal into real and imaginary parts, attempts to correlate both real and imaginary parts for a plurality of chip sequences (e.g., I and Q chip sequences), and combines the real and imaginary signals into a unified signal data stream. A preferred embodiment of this aspect of the invention uses a single bit digitization of the received spread spectrum signal to preserve only phase information for inexpensive digital processing. Another preferred embodiment of this aspect of the invention uses two-bit digitization of the received spread spectrum signal. In an alternative embodiment of the invention, the receiver uses self-synchronization techniques for despreading and correlation.

These aspects of the invention are described with reference to a preferred embodiment of the invention, in which a single parallel correlator and a plurality of 32 serial correlators are combined so as to allow correlation and recognition of any of 32 distinct symbols for a spread spectrum code sequence of 32 chips. Each of the 32 distinct symbols is associated with a distinct 5-bit pattern. A sixth bit of information is transmitted for each symbol by differential phase encoding at the transmitter and is phase decoded at the receiver.

A transmitter capable of phase encoding divides a data stream into a data symbol portion and a phase selection portion. The data symbol portion is used to select one of a plurality of symbol codes for transmission. The phase selection portion is used to differentially phase encode the selected symbol code prior to transmission. The transmitter may use a CPM or related technique to transmit the phase encoded symbol codes.

A preferred receiver receives the superposed spread spectrum signal and simultaneously attempts to correlate for a plurality of chip sequences (such as I and Q chip sequences), and derives a real correlation signal and an imaginary correlation signal. For each received symbol, the receiver determines which of a plurality of phase sectors the phase angle lies in. The receiver compares the difference between the phase sector of the. present symbol and the phase sector of a preceding symbol. For biphase encoding, if the difference in closer to 0°, then the receiver outputs a first bit, and if the difference is closer to 180°, the receiver outputs a second bit. Higher degrees of phase encoding (e.g., quadraphase or octiphase) may also be used.

Brief Description of the Drawings

Figure 1 is a block diagram of a spread spectrum communication transmitter and receiver as known in the art.
Figure 2 depicts a pattern of cells for use in spread spectrum communication.
Figure 3 is a graph of phase changes over time for an MSK signal.
Figures 4A-4C are a set of graphs showing a relationship among phase components.
Figure 5A is a block diagram showing means for generating a CPM spread spectrum signal.
Figure SB is a graph of I and Q values.
Figure 6 is a block diagram of a spread spectrum transmitter.
Figure 7 is a block diagram showing a spread spectrum receiver.
Figure 8 is a block diagram.showing a spread spectrum receiver for reference;
Figure 9 is a scatter diagram comparing transmitted and received I and Q signals.
Figure 10 is a block diagram of an embodiment of a spread spectrum receiver using separable real and imaginary parts of a received spread spectrum signal.
Figures 11A-11F are diagrams showing a representation of transmitted and received waveforms for different phase values.

Figure 12 is a block diagram of an embodiment of spread spectrum receiver using serial correlation for separable real and imaginary parts of the received spread spectrum signal;

Figure 13 is a block diagram of an embodiment of spread spectrum receiver using self-synchronized correlation for separable real and imaginary parts of the received spread spectrum signal;

Figure 14A is a diagram of an alternative transmission protocol;

Figure 14B is an exemplary SQAM waveform generated by a transmitter using separate I and Q components;

Figure 14C is a block diagram of a preferred transmission protocol;

Figure 15 is a block diagram of a correlator matched to a specific code sequence;

Figures 16A and 16B-16C are block diagrams of two different embodiments of a receiver for carrying out phase decoding to obtain extra information from the received signal;

Figure 17 is a block diagram of a preferred receiver for carrying out phase decoding in a 32 symbol transmission technique in accordance with the embodiment of the receiver shown in Figs. 16B and 16C;

Figures 18A and 18B are phase map diagrams for an 8-sector phase map and 16-sector phase map, respectively, and Figure 18C is a preferred 16-sector phase map diagram having a phase reference offset from zero.

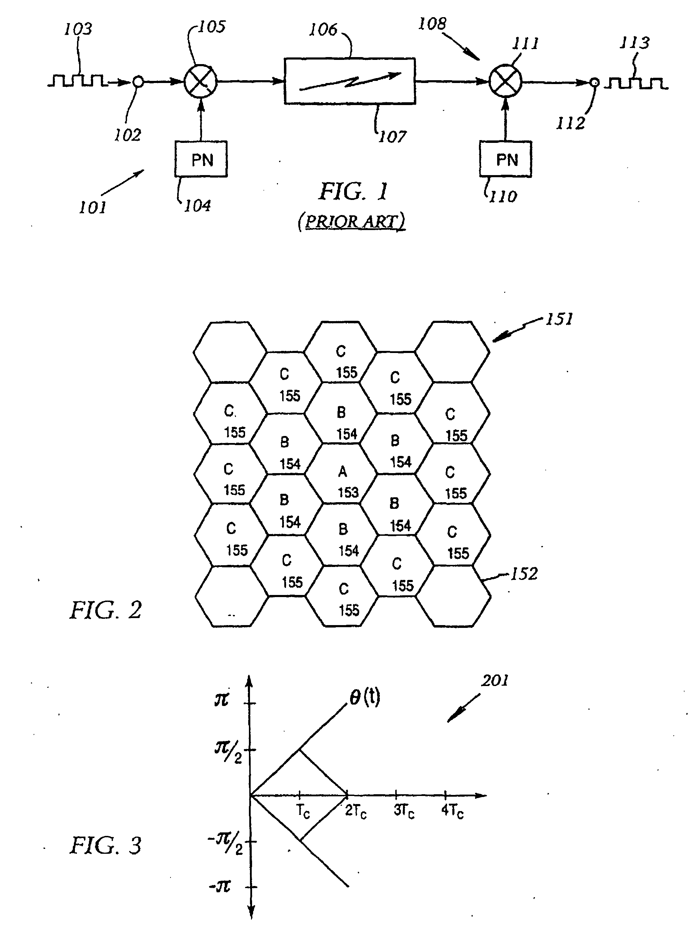

Figure 1 is a block diagram of a spread spectrum communication transmitter 101 and receiver 108 as known in the art.

The spread spectrum transmitter 101 of Fig. 1 comprises an input port 102 for input data 103, a transmitter chip sequence generator 104, and a modulator 105. The transmitter 101 thereby transmits a spread spectrum signal 106 over a transmission channel 107. The transmission channel 107 may comprise an RF channel, but may also comprise other transmission media, such as modulated laser, ultrasound, or fluidic systems. The spread spectrum receiver 108 of Fig. 1 comprises a receiver chip sequence generator 110, a demodulator 111, and an output port 112 for generating output data 113. In the Fig. 1 system, a single chip sequence, which appears essentially random to others not knowing the spreading code upon which it is based, may be identically generated by both the transmitter generator 104 and the receiver generator 110. An extensive discussion of spread spectrum communication, spreading codes, and chip sequences may be found in R. Dixon, Spread Spectrum Systems with Commercial Applications (J. Wiley & Sons, 3d ed. 1994).

Figure 2 depicts a pattern of cells for use in spread spectrum communication.

In the preferred cellular environment of Fig. 2, a region 151 for communication may be divided into a set of cells 152, each of which may be assigned a frequency and a set of spread spectrum codes for communication. A first cell 153 may generally be found adjacent to a set of distance-one neighbors 154 and a set of distance-two neighbors 155. In a preferred embodiment, a plurality of frequencies f1, f2 and f3, and a plurality of code sets c1, c2, and c3, may be configured in a pattern of cells 152 so that the no distance-one neighbors 154 or distance-two neighbors 155 of a particular cell 153 has the same combination of frequency and code set as the cell 153.

Other and further information about a preferred cellular environment in which the invention may operate may be found in U.S. Patent No. 5,402,413 which is assigned to the assignee of the present application.

Known CPM spread spectrum signals include several variations; these include minimum shift keying (MSK) and its variations, e.g., Gaussian pre-filtered MSK (GMSK), superposed quadrature amplitude modulation (SQAM), and staggered quadrature offset raised cosine modulation (SQORC). These variations are known in the art. Explanations of various types of CPM techniques may be found in the following: Frank Amoroso and James A. Kivett, "Simplified MSK Signaling Technique," : IEEE Transactions on Communications, April 1977, pp. 433-441; Mark C. Austin and Ming U. Chang, "Quadrature Overlapped Raised-Cosine Modulation," IEEE Transactions on Communications, Vol. Com-29, No. 3, March 1981, pp. 237-249; Kazuaki Murota and Kenkichi Hirade, "GMSK Modulation for Digital Mobile Radio Telephony," IEEE Transactions on Communications, Vol. Com-29, No. 7, July 1981, pp. 1044-1050; and J.S. Seo and K. Feher, "SQAM: A New Superposed QAM Modem Technique," IEEE Transactions on Communications, Vol. Com-33, March 1985, pp. 296-300. The invention is generally described with regard to MSK signals. However, other variants of MSK and other CPM signals are within the scope of the invention.

An MSK signal is generally characterized by the fact that phase changes linearly within each chip time, and that the phase change over a single chip time is $\pm\pi/2$ radians ($\pm90$ degrees). The rate of phase change for a single chip time is $\pm k$, for a suitable value $k$, and is linear and continuous everywhere except at chip boundaries.

The above described characteristics of MSK signals may be further explained with reference to Fig. 3, which is a graph showing possible changes in phase for an MSK signal over time. In Fig. 3, the x-axis is time and the y-axis is signal phase. In a first chip time from zero to Tc, the phase $\theta(t)$ changes from 0 to $\pi/2$ or $-\pi/2$. In a second chip time, from Tc to 2 Tc, the phase $\theta(t)$ changes from $+\pi/2$ to 0 or $+\pi/2$ to $+\pi$, or from $-\pi/2$ to 0 or $-\pi/2$ to $-\pi$, and so on.

An MSK signal s(t) may be considered to comprise two offset signals, i(t) and q(t), which represent the phase of the carrier signal. At any instant of time the phase of the carrier signal may be expressed as:

$$\theta(t) = -\text{Tan}^{-1}[q(t)/i(t)]$$

Thus, $i(t) = \cos\theta(t)$, and $q(t) = \sin\theta(t)$.

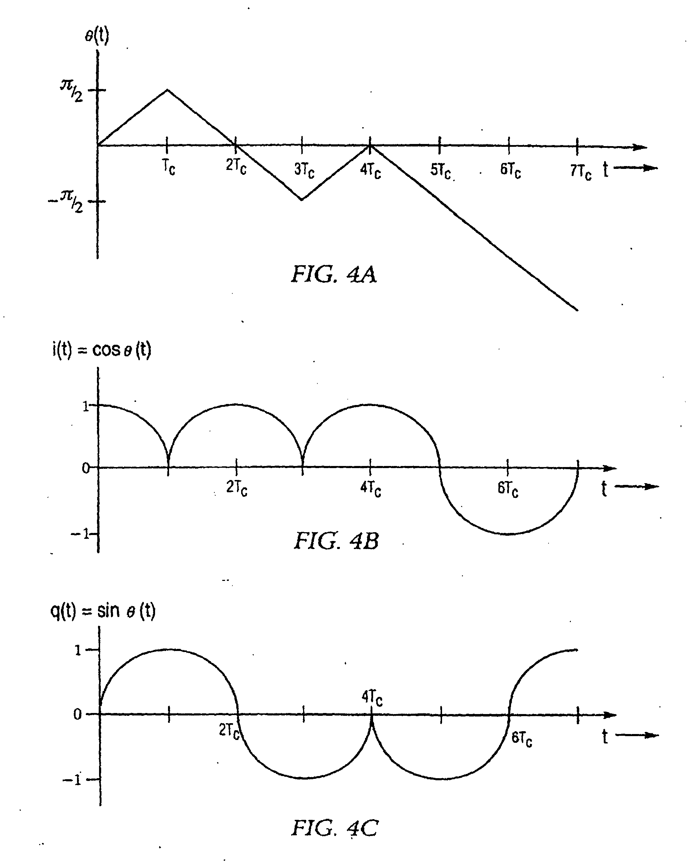

Since the phase of the MSK signal varies linearly from one chip time to the next chip time, $i(t)$ and $q(t)$ may consist of half sinusoidal waveforms as shown in' the Figs. 4A-4C. In Figs. 4A-4C, the x-axis is time and the y-axis is signal phase. Figure 4A is a graph showing an example of how the phase $\theta(t)$ may change for a particular MSK signal in each chip time from 0, Tc, 2Tc, 3Tc, 4Tc, 5Tc, and so on, for the chip sequence "11101001...." As noted, during each chip time the phase varies for an MSK signal by $\pi/2$ in either a positive or negative direction. Figures 4B and 4C are graphs showing $i(t)$ and $q(t)$ waveforms, respectively, which correspond to the varying phase $\theta(t)$. Because of the nature of the MSK signal's phase $\theta(t)$ (e.g., that it is linear and varies only by $\pi/2$ each chip period), the $i(t)$ signal comprises a sequence of partial cosine waveforms, and the $q(t)$ signal comprises a sequence of partial sine waveforms. Each of $i(t)$ and $q(t)$ comprises a half-waveform over a timespan of 2Tc; that is, $i(t)$ and $q(t)$ occur at half the chip rate.

An $i(t)$ waveform and a $q(t)$ waveform can be generated from a chip stream $c(t)$ and combined so as to produce an MSK signal -- i.e., a signal having a phase which varies linearly as desired in either a positive or a negative direction by an amount of $\pi/2$ each chip time. In order to generate $i(t)$ and $q(t)$, the original chip stream $c(t)$ may be demultiplexed into two separate chip streams $C_{even}(t)$ and $C_{odd}(t)$, each having half the chip rate of the original chip stream $c(t)$. In the described embodiment, the $i(t)$ signal is associated with the odd-numbered chips, and the $q(t)$ signal is associated with the even-numbered chips.

Thus, the $i(t)$ signal comprises a sequence of half-sinusoidal waveforms, one for each odd chip. Each half sinusoid may be positive for a "1" chip and negative for a "0" chip:

$$i(t) = C_{odd}(t)\cos\theta(t) \tag{203}$$

where $C_{odd}(t)$ comprises the odd-numbered chips from the chip stream to be transmitted. Similarly, the $q(t)$ signal comprises a sequence of half-sinusoidal waveforms, one for each even chip:

$$q(t) = C_{even}(t)\sin\theta(t) \tag{204}$$

where $C_{even}(t)$ comprises the even-numbered chips from the chip stream to be transmitted.

The $i(t)$ and $q(t)$ signals may be used to modulate a carrier signal operating at frequency $\omega_0$ by summing $i(t)$ and $q(t)$ in phase quadrature so as to generate an MSK signal $s(t)$ having a linearly varying phase $\theta(t)$. A block diagram showing means for generating a CPM spread spectrum signal is depicted in Fig. 5A. The signal $i(t)$ is multiplied with a signal $A\cos\omega_0 t$ by multiplier 250, which provides an output to a summer 252. The signal $q(t)$ is multiplied with a signal $A\sin\omega_0 t$ by multiplier 251, which also provides an output to the summer 252. The summer 252 sums its inputs and produces an output signal $s(t)$.

The relationship between the transmitted signal $s(t)$ having varying phase $\theta(t)$, and the $i(t)$ and $q(t)$ signals is shown in the following equations:

$$s(t) = \text{Re}\{A\exp(j[-\omega_0 t + \theta(t)])\}$$

$$= \text{Re}\{A\exp(-j\omega_0 t)\exp(j\theta(t))\}$$

$$= \text{Re}\{A[\cos\omega_0 t - j\sin\omega_0 t][i(t) + jq(t)]\}$$

$$= A\,i(t)\cos\omega_0 t + A\,q(t)\sin\omega_0 t \tag{207}$$

where A is an amplification factor, Re{} represents the real part of a complex value, and j is the square root of -1. Note that $u(t) = i(t) + jq(t)$ represents the complex envelopé of $s(t)$.

As noted herein, $i(t)$ and $q(t)$ each comprises every other chip from the chip stream $c(t)$; $i(t)$ comprises the odd-numbered chips 1, 3, 5, ...; $q(t)$ comprises the even-numbered chips 2, 4, 6, .... The transmitted signal $s(t)$, generated from signals $i(t)$ and $q(t)$, therefore comprises all of the chips. Because $q(t)$ is derived from the even chips while $i(t)$ is derived from the odd chips, $q(t)$ is delayed by one chip time from $i(t)$; thus, $q(t)$ and $i(t)$ are offset signals.

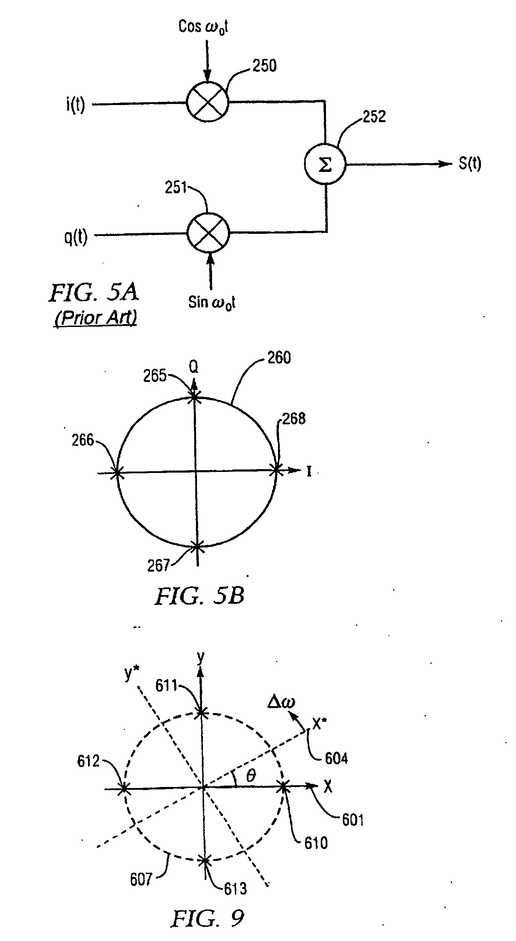

It is important to note that, because $i(t)$ and $q(t)$ are staggered, as $i(t)$ reaches its maximum (or minimum) value q(t) will be zero, and vice versa. This relationship between i(t) and q(t) allows phase change sequences of $\pm\pi/2$ over one chip time Tc (unlike, for example, QPSK or OQPSK). Figure 5B is a graph of I and Q values, in which the x-axis represents values of i(t) and the y-axis represents values of q(t). Each <i(t), q(t)> pair falls at a given instant of time on the circle 250. Maximum and minimum values for i(t) and q(t) are shown where the circle 260 intersects the x-axis and y-axis at points 265 through 268; these points 265 through 268 also represent the possible values of <i(t), q(t)> pairs at chip boundary times.

Alternative encoding methods such as GMSK, SQAM, or SQORC, differ from MSK in that phase changes of less than $\pm\pi/2$ are allowed. In general, GMSK, SQAM, and SQORC all use a form of pre-filtering the MSK i(t) and q(t) signals to reduce transmission bandwidth. This pre-filtering has the general effect of reducing the high-frequency components generated by the sharp phase reversals in the MSK i(t) and q(t) signals. For GMSK, pre-filtering may also result in intersymbol interference over several chip times, the effect of which may be mitigated with a trellis decoder. In SQAM or SQORC, the final frequency envelope is no longer constant, but is still nearly so,

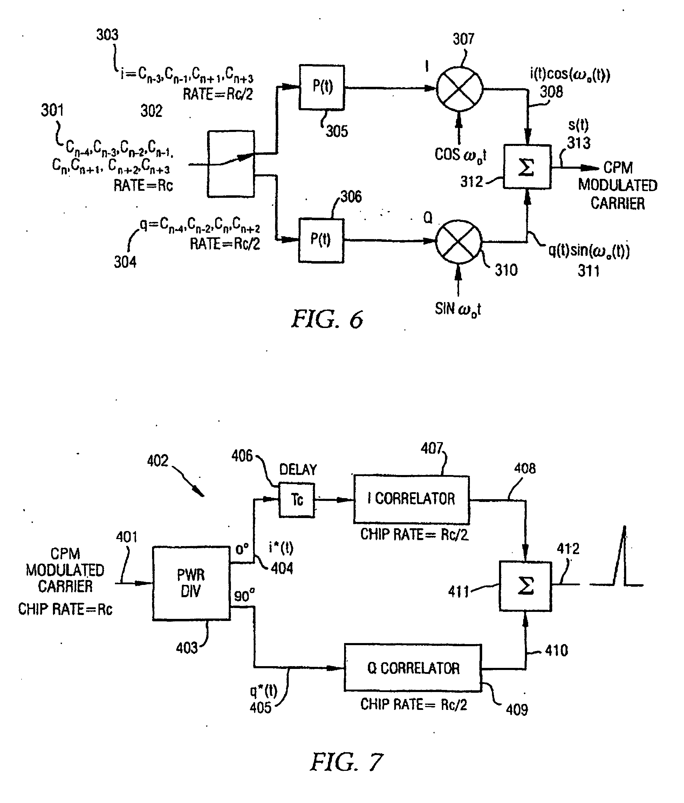

Figure 6 is a block diagram of a spread spectrum transmitter, described for reference.

In the transmitter of Fig. 6, a chip stream c(t) 301 is provided to a demultiplexer 302, which divides the chip stream 301 into a set of odd chips $C_{odd}$(t) 303 for the i(t) signal and a set of even chips $C_{even}$(t) 304 for the q(t) signal. The chip stream c(t) 301 may comprise the result of a pseudo-noise ("PN") code modulated with a data stream (as in direct sequence spread spectrum communication), or may comprise a sequence of chip codes corresponding to predetermined symbols such as may be done, for example, in code shift keying (CSK) techniques.

The odd chips 303 and the even chips 304 are each coupled to first and second waveform generators P(t) 305 and 306 respectively. The waveform generators P(t) may generate a half-sinusoidal waveform, positive or negative, as described herein.

The output of the first waveform generator 305 (i.e., receiving the odd chips 303) corresponds to the signal i(t) and is coupled to a first multiplier 307, which modulates a carrier signal cos $w_0$t to generate a signal $s_1$(t) 308 corresponding to i(t) cos $w_0$t. The output of the second waveform generator 306 (i.e., receiving the even chips 304) corresponds to the signal q(t), which, as mentioned, is delayed by one chip time Tc from the signal i(t). The output of the second waveform generator 306 is coupled to a second multiplier 310, which modulates a carrier signal sin $w_0$t to generate a signal $s_2$(t) 311 corresponding to q(t) sin $w_0$t.

The signals $s_1$(t) 308 and $s_2$(t) 311 are coupled to a summer 312, which combines its inputs and generates a superposed signal s(t) 313. The signal s (t) may be amplified and transmitted by a transmission system, such as a radio transmission system, coupled to the transmission channel 107.

The chip stream c(t) may be generated by modulating a pseudo-noise code with data to be transmitted such as 'is known in direct sequence spread spectrum modulation. In a preferred embodiment, the chip stream c(t) comprises a plurality of symbol codes, each symbol code representing a symbol indicative of one or more data bits of information. Instead of directly modulating input data with a pseudo-noise code, sequences of data bits are translated into symbols which are used to select from a plurality of symbol codes located in a table. For example, five data bits may represent a symbol; thus, there may be 32 possible symbols representing all possible combinations of five data bits. Each symbol is associated with a unique symbol code, so that thirty-two symbol codes (or sixteen symbol codes and their inverses) may represent all possible symbols. For each symbol to be transmitted, the appropriate symbol code is selected among the thirty-two available. Thus, the chip stream c(t) may comprise a sequence of symbol codes.

Each symbol code may be, for example, 32 chips in length, or some other appropriate number of chips in length (preferably an even number of chips).

In a like manner, the demultiplexer 302 may comprise a table of half symbol codes. In particular, the demultiplexer 302 may comprise a Q-lookup table and I-lookup table. For every five bits of data to be transmitted (following the previous example), instead of looking up a symbol code from a table and demultiplexing it with demultiplexer 302, two half symbol codes may be read, one from the I-lookup table and one from the Q-lookup table. Each half symbol code may be clocked serially to the waveform generators 305, 306 for further processing. The system may comprise clocking logic which provides a delay of one chip time Tc to the half symbol code from the Q-lookup table.

Once a set of 32 unique symbol codes are selected, the contents of the I-lookup table and Q-lookup table can be generated by dividing each symbol code into even and odd chips, and using the even chips for the'half symbol codes in the Q-lookup table and the odd chips for the half symbol codes in the I-lookup table.

Figure 7 is a block diagram of a spread spectrum receiver.

The transmitted signal s(t) 313 may undergo attenuation, addition of noise, multipath superposition, and other known and unknown effects of the transmission channel 107. Accordingly, the received signal s*(t) 401 may differ from the transmitted signal s(t) 313 in known and unknown ways.

Received signal s*(t) may be despread using multiple correlators keyed to I and Q chip streams. Because CPM spread spectrum signals may be thought of as the superposition of time staggered signals created from I and Q chip streams (each at half the chip rate), a receiver according to one embodiment of the present invention uses two correlators, one programmed with the I-chip-sequence and one programmed'with the Q-chip-sequence and both operating at half the chip race, to decode the received signal, and then combines the outputs of the two correlators.

In the receiver of Fig. 7, the received signal s*(t) 401 is coupled to a CPM correlator 402 for recognizing a chip sequence in the received signal s*(t) 401. The CPM correlator 402 comprises a power divider 403 for generating duplicate signals, an i*(t) signal 404 with a 0 degree phase delay, and a q*(t) signal 405 with a 90 degree phase shift.

The i*(t) signal 404 is coupled to a delay 406, which delays the i*(t) signal 404 by one chip time Tc to allow simultaneous generation of correlation pulses by the I correlator 407 and the Q correlator 409. Thus, the delayed i*(t) signal is coupled to an. I correlator 407, and the q*(t) signal 405 is coupled directly to a Q correlator 409.

The I correlator 407 operates at a chip rate of Rc/2, where Rc is the chip rate (i.e., l/Tc) of the received signal s*(t) 401. The I correlator 407 may comprise one of several types of correlators, e.g., a surface-acoustical-wave (SAW) correlator, a capped-delay-line (TDL) correlator, or a serial correlator. Examples of suitable correlators may be found in U.S. Pat. No. 5,016,255 entitled "Asymmetric Spread Spectrum Correlator" or in U.S. Pat. No. 5,022,047 entitled "Spread Spectrum Correlator", both of which are issued in the name of inventors Robert C. Dixon and Jeffrey S. Vanderpool. The I correlator 407 produces an output I correlation signal 408 indicating a degree of match between the delayed i*(t) signal and a predetermined I-chip-sequence.

The Q correlator 409 similarly operates at a chip race of Rc/2, and may similarly comprise any of a number of suitable correlators such as those described in the patents referenced in the preceding paragraph. The Q correlator 409 produces an output Q correlation signal 410 indicating a degree of match between the q*(t) signal and a predetermined Q-chip-sequence.

The I correlation signal 408 and the Q correlation signal 410 are coupled to a summer 411, which combines its inputs and produces a unified correlation signal 412. Because the i*(t) signal is delayed by delay 406, the I correlation signal 408 and Q correlation signal 410 occur simultaneously. The unified correlation signal 412 is used to determine a data stream d(t) from which the chip sequence c(t) was generated.

The I correlator 407 and the Q correlator 409 thus jointly identify the chip sequence in the received signal s*(t) 401. The I correlator 407 is configured to recognize the odd chips of the chip sequence, while the Q correlator 409 is configured to recognize the even chips of the chip sequence. When the entire correlation sequence appears in the received signal s*(t), the sum of the I correlation signal 408 and the Q correlation signal 410 is at a maximum, and may be compared against a predetermined threshold to allow recognition of the chip sequence. A unified correlation signal 412 is produced when a chip sequence is recognized.

Alternatively, instead of comparing the unified correlation signal 412 to a predetermined threshold, a system may be configured so as to have a plurality (e.g., 32) of CPM correlators 402 operating in parallel, each tuned to recognize a different code sequence. The outputs of all 32 CPM correlators may be summed and, when the sum is at a predetermined maximum level, the CPM correlator 402 with the highest magnitude output may be chosen by a best-of-M detector or.similar means as indicative of the data stream d(t). For example, in. a CSK system, each of 32 CPM correlators may attempt in parallel to recognize a code sequence, and the one with the highest magnitude correlation signal may be assumed to indicate the received chip stream. The recognized chip stream may correspond to a data symbol from which a portion of the data stream d(t) may be recovered.

The CPM correlator 402 may be used in conjunction with techniques described in U.S. Patents 5,016,255 or 5,022,047, both of which are assigned to the assignee of the present invention. In those techniques, each data bit or data symbol of the data stream d(t) may be encoded by modulation with the entire length of a pseudo random chip sequence generated from a chip sequence code. For example, if a chip sequence code identifies a pseudo random chip sequence that repeats after 32 chips, each data bit of the data stream d(t) may be modulated with all 32 of those chips.

However, there is no requirement that the CPM correlator 402 be used with those particular techniques. For example, the CPM correlator may be used with other spread spectrum techniques to recognize a' correlation signal that is used to synchronize the transmitter 101 and the receiver 108. Also, the. CPM correlator 402 may be used in conjunction with a self-synchronizing or auto-synchronizing spread spectrum technique such as described elsewhere herein in more detail.

The I and Q chip sequences are preferably of equal length; thus, each CSK symbol code is preferably an even number of chips in length so as to avoid a 90-degree phase uncertainty between symbol codes when despreading is attempted.

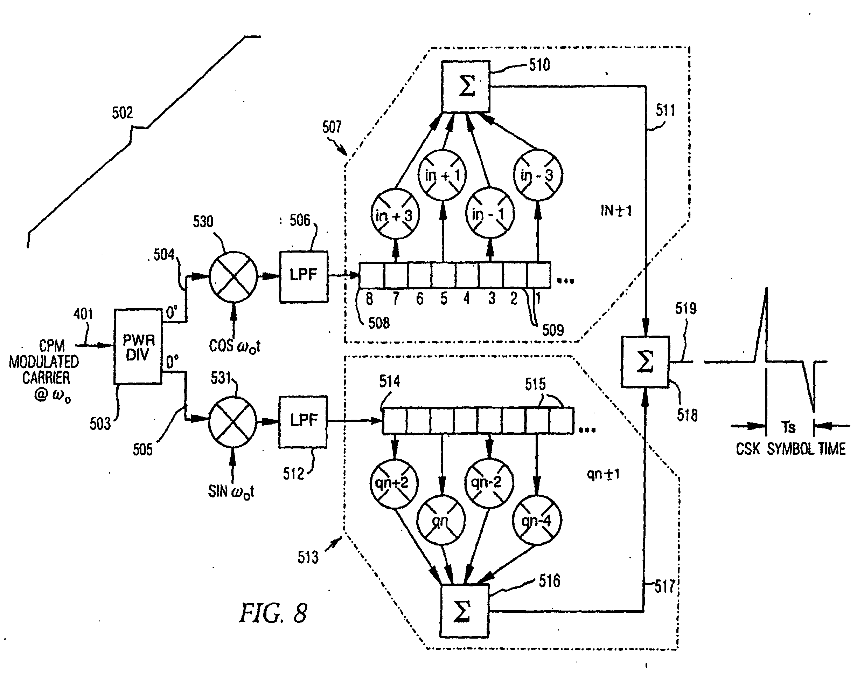

Figure 8 is a block diagram of a coherent spread spectrum receiver, described for reference.

The received signal s*(t) 401 in the receiver of Fig. 8 is coupled to a CPM correlator 502 for recognizing a chip sequence in the received signal s*(t) 401. The CPM correlator 502 comprises a power divider 503, which produces duplicate signals 504 and 505, each with a 0 degree phase delay. Such power dividers are known in the art and are generally preferred for the CPM correlator 502 over the power divider 403 shown in Fig. 7. While a phase delay of 90 degrees between i*(t) and q*(t) was imposed by use of the power divider 403 in Fig. 7, a 90-degree phase delay in the Fig. 8 receiver ; is produced by' separately multiplying the signals 504 and 505 with cosine and sine signals, respectively.

The signal 504 is multiplied with a $\cos w_0 t$ signal by I multiplier 530 and filtered by a I low pass filter 506 to provide an i*(t) signal. The signal 505 is multiplied by a sin $\omega_0 t$ signal by Q multiplier 531 and filtered by a Q low pass filter 512 to provide a q*(t) signal.

The outputs of the I low pass filter 506 and the Q low pass filter 512 generally appear for MSK' as half sinusoidal waveforms corresponding to those generated in the transmitter from P(t) generators 305, 306.

The i*(t) signal output from I low pass filter 506 is coupled to an I correlator 507. The I correlator 507 comprises a register 508 having a sequence of chips 509. The register 508 may be an analog shift register, a tapped delay line having a plurality of taps, or any other suitable storage means. The odd chips are coupled by a plurality of multipliers to an I summer 510, which combines its inputs and produces an output I correlation signal 511.

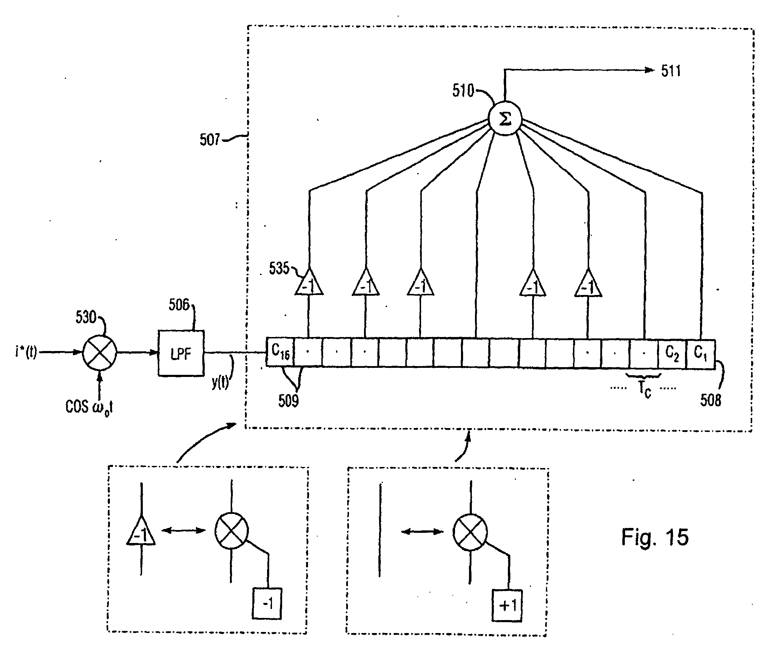

An example of the path of the I correlator 507 is shown in Fig. 15. As described with respect. to Fig. 8, the filtered i*(t) signal is coupled to a register 508. The register 508 comprises a series. of chips 509 along which the filtered i*(t) signal propagates. The register 508 is matched to a particular code sequence. Thus, in the example of Fig. 15, the sequence of odd chips which will result in a match is $C_{odd}(t) = 11001000$. At time $t = 16Tc$, the first chip $C_1$ is compared with the first chip in the sequence of $C_{odd}(t)$, and a "1" is generated if the chips are equal. Each of the other odd chips in the register 508 is likewise compared against the programmed sequence. A comparison between any two chips may be carried out using a multiplier or an exclusive-OR gate. The comparison values are provided to a summer 510 which generates a maximum pulse when the chip sequence for which the correlator 507 has been programmed matches the received chip sequence. In Fig. 15, the branches having a "-1" correspond to chips for which a "0" in the received chip sequence will generate a match, while the other branches correspond to chips for which a "1" in the received chip sequence will generate a match.

Returning to Fig. 8, the q*(t) signal output from the Q low pass filter 512 is coupled to a Q correlator 513. The Q correlator 513 similarly comprises a register 514 having a sequence of chips 515. As with the odd chips in the I correlator 507, the even chips are coupled to a Q summer 516, which combines its inputs and produces an output Q correlation signal 517.

The I correlation. signal 511 and the Q correlation signal 517 are coupled to a summer 518, which combines its inputs and produces a unified correlation signal 519. Because the I correlation signal 511 is derived from the odd chips while the Q correlation signal 517 is derived from the even chips (which precede the odd chips by one chip time Tc), the correlation signals 511, 517 occur simultaneously, and there is no need for a separate delay element such as delay 406 shown in Fig. 7. The unified correlation signal 519 is used to determine a data stream d(t) from which the chip sequence c(t) was generated in a manner similar to that explained above with reference to Fig. 7.

The Fig. 8 receiver operates best with a coherent carrier reference at frequency $\omega_0$ and assumes such is available. Methods are known in the art for obtaining a coherent carrier reference, such as the use of phase estimating circuitry. Where very rapid acquisition times are necessary, such as in certain high-speed time division multiple access (TDMA) systems using CPM spread spectrum techniques, other arrangements (such as the non-coherent receiver embodiments described herein) may generally be preferred.

In a non-coherent CPM system, the receiver 108 of Fig. 1 may not have available an exact copy of the carrier signal at frequency $\omega_0$ used by the transmitter 101. Rather, the receiver 108 generates a local carrier signal having a frequency $\omega_1$, which in practice may differ in frequency and phase from the transmitter's carrier signal:

$$\cos \omega_1 t = \cos (\omega_0 + \Delta\omega)t + \theta \tag{603}$$

where $\Delta\omega$ = frequency difference and $\theta$ = phase difference.

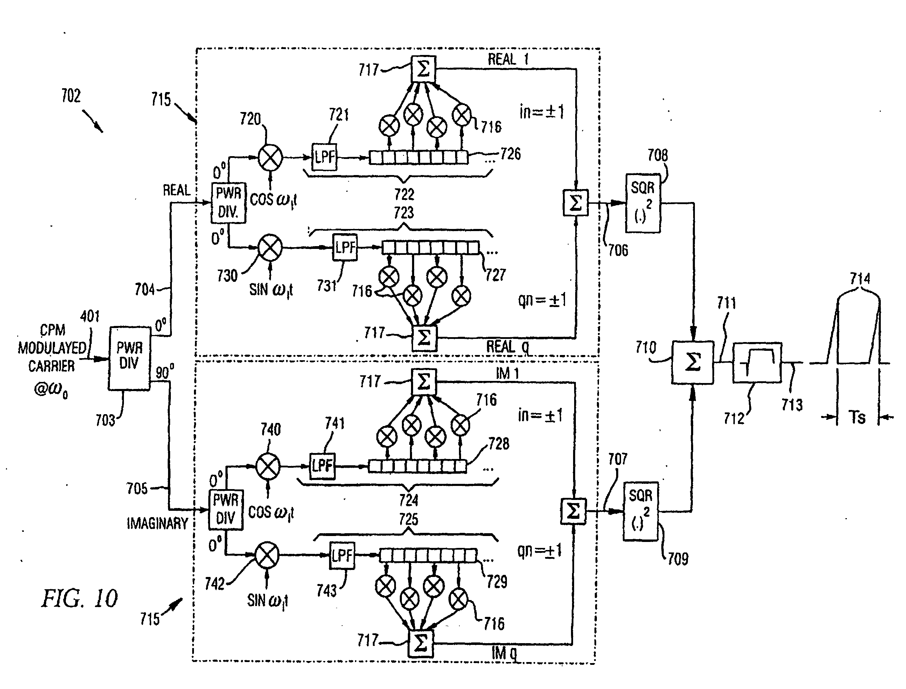

Figure 10 is a block diagram of a non-coherent spread spectrum receiver for receiving and despreading a CPM spread spectrum signal without the need for a locally generated coherent reference signal $\omega_0$. The receiver of Fig. 10 can be used. to process a received CPM signal by splitting the received spread spectrum signal into separable real and imaginary parts, splitting the real and imaginary parts into I and Q portions, mixing the real I and Q portions and the imaginary I and Q portions with a non-coherent reference signal having a frequency near that expected of the received signal to obtain real I and Q streams and imaginary I and Q streams, filtering the multiplied signals, correlating separately the I and Q streams for each of the real and imaginary parts to obtain a real I and Q correlation pulse and an imaginary I and Q correlation pulse, combining the I and Q correlation pulses separately for the real and imaginary parts to provide a combined real and a combined imaginary correlation signal, squaring the combined real and imaginary correlation signals to generate a squared real and a squared imaginary correlation pulse, and combining the squared real and imaginary correlation signals into a unified correlation signal.

The operation of the receiver of Fig. 10 may be explained graphically with reference to Fig. 9, which is a scatter diagram comparing real and imaginary values as transmitted and as received in a non-coherent receiver. For simplicity, the explanation below assumes the transmission channel to be distortionless and have unlimited bandwidth. The transmitter's coordinate system 601 is represented by an x-axis and y-axis, with the x-axis representing values of i(t) and the y-axis representing values of q(t). A set of four points 610 through 613 represents transmitted sampled value pairs for $<i(t_n),q(t_n)>$. The pairs 610 through 613 represent coordinates <1,0>, <0,1>, <-1, 0>, and <0,-1>, respectively.

A receiver's coordinate system 604 is represented by an x*-axis and a y*-axis shown as dashed lines in Fig. 9. The receiver's coordinate system 604 is assumed to differ from the transmitter's coordinate system 601 due to frequency and phase differences. The receiver's coordinate system 604 rotates with respect to the transmitter's coordinate system 601 at a rate proportional to $\Delta\omega$, the frequency difference ("beat frequency") between the transmitter and receiver reference signals. For sufficiently small $\Delta\omega$ (such as may be expected for the time period of interest over which correlation for a data symbol will occur -- e.g., 32 chip periods), the receiver's coordinate system 604 approximately equals the transmitter's coordinate system 601, except for a phase difference e which remains relatively constant for short periods of time. In order to maintain such a condition, the beat frequency $\Delta\omega$ preferably should be less than about 1/4 the symbol rate. For example, with a symbol rate of 156.25k symbols/second (5 Mchips/second), the beat frequency $\Delta\omega$ should be less than about 39 kHz for optimal operation.

Because the receiver's coordinate system 604 at a given instant appears rotationally shifted with respect to the transmitter's coordinate system 601, the $<i^*(t_n),q^*(t_n)>$ sampled pair recognized by the receiver 108 will be a point on the circle 607 corresponding to an $<i(t_n),q(t_n)>$ sampled pair in the transmitter's coordinate system 601 but shifted around circle 607 by an amount dependent on the phase difference θ. Accordingly, the perceived real value or i*(t) will differ from the transmitted i(t) value by an amount dependent upon cos θ due to the rotational difference between the coordinate systems 601 and 604, while the perceived imaginary value or q*(t) will also differ from the transmitted q(t) value by an amount dependent upon sin θ for the same reason. Thus, if the transmitted <i(n), q(n)> sampled values are <1, 0> and the phase offset θ is +30°, the received $<i^*(t_n), q^*(t_n)>$ sampled values are <cos +30°, sin +30°> or <0.866, 0.5>. Likewise, if the phase offset θ is +90° for the same transmitted values, the received $<i^*(t_n), q^*(t_n)>$ sampled values are <0, 1>.

From the above explanation, it is apparent that a correlator attempting to correlate for I and Q portions would be faced with a diminishing i*(t) value as θ varies from 0 to 90 degrees, yet at the same time an increasing q*(t) value. As θ grows, eventually the difference between <i(t), q(t)> and <i*(t), q*(t)> becomes so large that accurate correlation is cumbersome. Because of the phase difference θ, it is generally not possible to know in advance which quadrant of Fig. 9 the received signal s*(t) will be in relative to the transmitter's coordinate system 601. However, the present invention in one aspect addresses this problem by utilizing both real and imaginary parts of I and Q portions in order to despread the received s*(t) signal.

It may be noted that as the real portion of i*(t) decreases as θ varies from 0 to 90 degrees, the imaginary portion of i*(t) increases, Similarly, as the real portion of i*(t) increases (in magnitude) as θ varies from 90 to 180 degrees, the imaginary portion of i*(t) decreases. A similar phenomenon occurs with the real and imaginary portions of q*(t). The receiver of Fig. 10 takes advantage of the complementary aspects of the real and imaginary portions of the received i*(t) and q*(t) signal portions, and accordingly analyzes both the real and imaginary parts of the I and Q signals in order to make an effective correlation.

In the Fig. 10 embodiment, the received signal s*(t) 401 is coupled to a non-coherent CPM correlator 702 for recognizing a correlation sequence in the received signal s*(t) 401. The non-coherent CPM correlator 702 comprises a power divider 703, which produces duplicate signals Real*(t) 704 having a 0-degree phase delay and Imag*(t) 705 having a 90-degree phase delay. Real*(t) 704 and Imag*(t) 705 may be viewed as the real and. imaginary parts of the received signal s*(t) 401.

The Real*(t) signal 704 is coupled to a CPM correlator 715 similar to CPM correlator 502 of Fig. 8, with the exception that the local reference signal is different, as described below. The CPM correlator 715 produces a real correlation signal 706. The Imag*(t) signal is coupled to a second CPM correlator 715 which produces an imaginary correlation signal 707. The real correlation signal 706 is coupled to a squaring device 708, which computes the square of its input. The imaginary correlation signal 707 is likewise coupled to a squaring device 709, which computes the square of its input. The outputs of the squaring devices 708 and 709 are coupled to a summer 710, which combines its inputs to produce a unified correlation signal 711 which is the sum of the squares of the real correlation signal 706 and the imaginary correlation signal 707. The unified correlation signal 711 is coupled to a square root device 712 which takes the square root of its input, and generates a final correlation signal 713 comprising correlation pulses 714. The time between correlation pulses 714 may be one symbol code time period Ts if CSK is employed.

A primary difference between the CPM correlators 715 shown in Fig. 10 and the CPM correlator 502 of Fig. 8 is that the CPM correlators 715 of Fig. 10 utilize non-coherent reference signals $\cos \omega_1 t = \cos (\omega_0 + \Delta\omega)t + \theta$ and $\sin \omega_1 t = \sin (\omega_0 + \Delta\omega)t + \theta$ for the I and Q portions, respectively, rather than $\cos \omega_0 t$ and $\sin \omega_0 t$ as generated in the coherent receiver of Fig. 8. The reference signals $\cos \omega_1 t$ and $\sin \omega_1 t$ may be generated from the same oscillator coupled to a power divider to keep the phase offset θ the same for both $\cos \omega_1 t$ and $\sin \omega_1 t$. The use of non-coherent reference signals causes the correlation signal generated by each CPM correlator 715 to have a magnitude dependent in part upon the phase difference 8.

The effect of using non-coherent reference signals on the ability to achieve correlation may be explained'first with reference to the I portion of the Real*(t) signal 704. The Real*(t) signal 704 may be represented as:

$$\text{Real*}(t) = \text{Re} \{A\, u(t)\, \exp(-j\omega_0 t)\}$$

where, as mentioned previously, $u(t) = i(t) + jq(t)$, which is the complex envelope of $s(t)$, and Re {} denotes the real portion of a complex value. The Real*(t) signal 704 is multiplied by multiplier 720 with a locally generated reference signal $\cos \omega_1 t = \cos (\omega_0 + \Delta\omega)t + \theta$, so that the output of multiplier 720 is:

$$\text{Re} \{A\, u(t)\, \exp(-j\omega_0 t)\} \cos \omega_1(t)$$

The output of the multiplier 720 is coupled to a low pass filter 721 which retains the baseband portion of the signal coupled to its input. Assuming that the non-coherent reference signal $\cos \omega_1 t$ differs from the transmitter reference frequency $\omega_0$ by only a phase difference (i.e., that the frequency change is negligible over the time period of interest), then the receiver reference signal may be expressed as:

$$\cos \omega_1 t = \cos (\omega_0 t + \theta)$$

The output $y(t)$ of the low pass filter 721 may therefore be expressed as :

$$y(t) = \text{LPF} [\, \text{Re} \{A\, u(t)\, \exp(-j\omega_0 t)\} \cos \omega_1(t) \,]$$

$$= \text{LPF} [\, \text{Re} \{A\, u(t)\, \exp[j(-\omega_0 t + \omega_1 t)]\} \,]$$

$$= (A/2)\, i(t) \cos(\omega_0 + \omega_1 t)t + (A/2)\, q(t) \sin(\omega_0 t + \omega_1 t)$$

$$= (A/2)\, i(t) \cos(-\theta) + (A/2)\, q(t) \sin (-\theta)$$

$$= (A/2)\, i(t) \cos \theta - (A/2)\, q(t) \sin \theta \tag{790}$$

where "LPF" denotes operation of the low pass filter 721.

By similar deduction the output $z(t)$ of the low pass filter 731 of the Q portion of the Real*(t) signal is as follows:

$$z(t) = (A/2)\, i(t) \sin(-\theta) + (A/2)\, q(t) \cos(-\theta)$$

$$= (-A/2)\, i(t) \sin \theta + (A/2)\, q(t) \cos \theta \tag{791}$$

Due to the 90-degree phase shift in signal 705, the output of low pass filter 741 of the I portion of the Imag*(t) signal is equal to $z(t)$ as derived above, while the output of low pass filter 743 of the Q portion of the Imag*(t) signal is equal to the inverse of $y(t)$ as derived above.

In operation, each of the four correlators 722 through 725 may contribute to correlation of the received CPM signal s*(t). Operation of the non-coherent CPM correlator 702 may be shown through several examples. As a first example, assume that 'the phase offset $\theta = 0°$; therefore, the outputs $y(t)$ and $z(t)$ for low pass filters 721 and 731, respectively, reduce to the following:

$$y(t) = (A/2)\, i(t)$$

and

$$z(t) = (A/2)\, q(t)$$

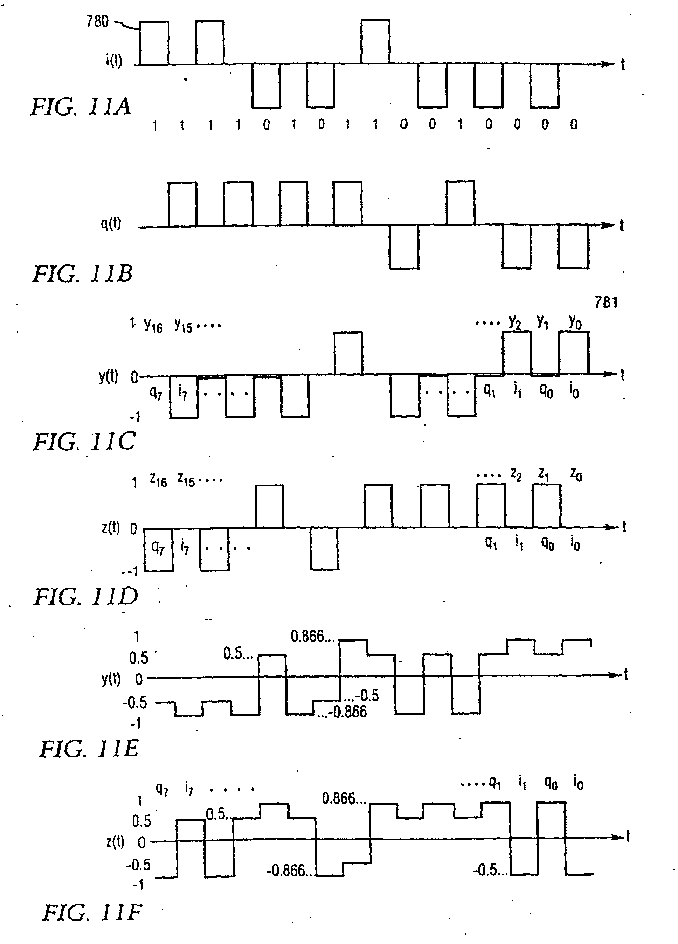

Selecting an amplification factor A = 2, the filter outputs of filters 721 and 731 then become y(t) = i(t) and z(t) = q(t). Assuming, for convenience, a code sequence length of 16 chips, then after 16 chip times (i.e., 16Tc) the entire sequence is contained within the correlation registers 726, 727, 728, and 729 in each CPM correlator 705. An illustrative chip stream c(t) = 1111010110010000 may be broken into sub-sequences $C_{odd}(t)$ = 11001000 and $C_{even}(t)$ = 11110100. It will further be assumed for sake of explanation that the waveform generator P(t) of the transmitter generates a return-to-zero (RZ) rectangular waveform having a duration of two chip periods, so that the transmitted i(t) and q(t) signals may be depicted as shown in Figs. 11A and Fig. 11B, respectively. Operation of the Fig. 10 correlator using CPM baseband signals instead of RZ signals can be. understood by observing that at time t = 16Tc, the peak values of the sinusoidal waveforms appear in the correlation registers 726, 727, 728 and 729, and correspond to the pulse height of the RZ waveform.

At the receiving end, the contents of the correlation registers 726 and 727 may be represented as shown in Figs. 11C and 11D, respectively. It can be seen that the waveform of Fig. 11C as reading from right to left is the same as that of Fig. 11A as reading from left to right. Similarly, the waveforms of Figs. 11B and 11D bear the same relationship. An output for each of the four correlators 722, 723, 724 and 725 may be obtained by pointwise multiplication of the chip values with the chip weighting factors 716 for each chip, and summation of the chip products by summers 717 to produce a correlation signal. The chip weighting factors 716 for correlator 725 are opposite in sign to the values for correlator 723. The chip weighting factors 716 for correlators 722 and 724 are the same sign.

Continuing with the present example in which θ = 0°, the output at time t = 16Tc for each of correlators 722 and 723, corresponding respectively to the I portion ("ReI") and the Q portion ("ReQ") of the Real*(t) signal, is eight, while the output for each of correlators 724 and 725, corresponding respectively to the I portion ("ImI") and the Q portion ("ImQ") of the Imag*(t) signal, is 0. The final correlation signal 713 at the instant 16Tc is:

$$Corr \ (t = 16Tc) = \{ \ (ReI + ReQ)^2 + (ImI + ImQ)^2 \ \}^{1/2}$$

$$= \{ \ (8 + 8)^2 \ \}^{1/2} = 16$$

The value of 16 is a maximum value indicating correlation for the particular chip sequence. If multiple codes are to be recognized, a plurality of non-coherent CPM correlators 702 may operate in parallel, each programmed to recognize a different code. The chip sequence corresponding to the highest correlation signal may be selected as the received chip sequence.

Assuming as a second example that θ = 30°, the contents of correlation registers 726 and 727 appear as shown in Figs. 11E and 11F, respectively. Selecting the amplification factor A = 2, the outputs y(t) and z(t) of low pass filters 721 and 731, respectively, may be represented as:

$$y(t) = (A/2) \ i(t) \ cos(30°) - (A/2) \ q(t) \ sin(30°)$$

$$= i(t) \ (0.866) - q(t) \ (0.5)$$

and

$$z(t) = (-A/2) \ i(t) \ cos(30°) + (A/2) \ q(t) \ sin(30°)$$

$$= -i(t) \ (0.5) + q(t) \ (0.866)$$

Pointwise vector multiplication of each of the chip valves in the correlation registers 726 through 729 with corresponding chip weights 716 yields the following outputs from summers 717:

$$ReI = (1) \ (0.866) + (1) \ (0.866) + (-1) \ (-0.866) + (-1) \ ($$

$$-0.866) \ ... = (8) \ (0.866) = 6.928$$

$$ReQ = (1) \ (0.866) + (1) \ (0.866) + (1) \ (0.866) \ ... =$$

$$(8) (0.866)$$

$$= 6.928$$

$$ImI = (1) (-0.5) + (1) (-0.5) + (-1) (0.5) + (-1) (0.5)$$

$$...$$

$$= -(8) (0.5) = -4.0$$

$$ImQ = (1) (-0.5) + (1) (-0.5) + (1) (-0.5) + (1) (-0.5)$$

$$...$$

$$= -(8) (0.5) = -4 .0$$

A final correlation signal 713 therefore is generated:

$$Corr (t = 16Tc) = \{ (6.928 + 6.928)^2 + ( -4 + -4)^2 \}^{1/2}$$

$$= 16$$

Thus, for a phase off set of $\theta = 30°$, the value of the final correlation signal 713 at t = 16Tc remains at the maximum level of 16.

As another example, a phase offset $\theta = 45°$ is assumed. The outputs y(t) and z(t) of low pass filters 721 and 731, respectively, become:

$$y(t) = i(t) (0.707) - q(t) (0.707)$$

and

$$z(t) = -i(t) (0.707) + q(t) (0.707)$$

Solving for the intermediate values ReI, ReQ, ImI, and ImQ yields:

$$ReI = (1) (0.707) + (1) (0.707) ... = (8) (0.707) =$$

$$5.657$$

$$ReQ = (1) (0.707) + (1) (0.707) ... = (8) (0.707) =$$

$$5.657$$

$$ImI = (1) (-0.707) + (1) (-0.707) ... = -(8) (0.707)$$

$$= -5.657$$

$$ImQ = (1) (-0.707) + (1) (-0.707) ... = -(8) (0.707)$$

$$= -5.657$$

A final correlator signal 713 is generated:

$$\text{Corr } (t = 16Tc) = \{ (2 \times 5.657)^2 + (2 \times -5.657)^2 \}^{1/2} =$$

$$16$$

Again, maximum correlation of 16 is realized even though the phase offset $\theta$ is not equal to 0.

A table can be constructed of (ReI + ReQ), (ImI + ImQ) values and correlation values versus phase off set $\theta$ for the correlator of Fig. 10:

| $\theta$ | $R_1 + R_q$ | $I_1 - I_q$ | Corr= |
|---|---|---|---|
| 0° | 16 | 0.0 | 16.0 |
| 30 | 13.856 | -8.0 | 16.0 |
| 45 | 11.314 | -11.314 | 16.0 |
| 60 | 8.0 | -13.856 | 16.0 |
| 90 | 0.0 | -16.0 | 16.0 |
| 120 | -8.0 | -13.856 | 16.0 |
| 135 | -11.314 | -11.314 | 16.0 |
| 150 | -13.856 | -8.0 | 16.0 |
| 180 | -16.0 | 0.0 | 16.0 |
| 210 | -13.856 | 8.0 | 16.0 |
| 225 | -11.314 | 11.314 | 16.0 |
| 240 | -8.0 | 13.856 | 16.0 |
| 270 | 0.0 | 16.0 | 16.0 |
| 300 | 8.0 | 13.856 | 16.0 |
| 315 | 11.314 | 11.314 | 16.0 |
| 330 | 13.856 | 8.0 | 16.0 |

As the phase offset $\theta$ increases beyond 45°, a higher percentage of the correlation value begins to come from the Imag*(t) signal path 705 rather than the Real*(t) signal path 704 of the non-coherent CPM correlator 702. At a phase offset of $\theta = 90°$, for example, all correlation is coming from the Imag*(t) signal path 705 and none from the Real*(t) signal path 704. The output 706 of the real CPM correlator 715 and output 707 of the imaginary CPM correlator 715 progress sinusoidally as a function of the phase offset $\theta$ and can be expressed as:

$$\text{Real*(t) correlation} = 16 \cos \theta$$

$$\text{Imag*(t) correlation} = -16 \sin \theta$$

$$\text{Corr} = \{ (16 \cos \theta)^2 + (-16 \sin \theta)^2 \}^{1/2} = 16$$

Thus, maximum correlation of 16 will be achieved regardless of the phase offset $\theta$. The use of multiple correlators as configured in the manner shown in Fig. 10 allows successful correlation regardless of which quadrant of Fig. 9 the receiver operates with respect to the transmitter.

It should be noted that at chip times other than multiples of 16Tc (for the example of chip.sequence of 16 chips), the correlation output will be a function of the cross correlation value between the $i(t_n)$ and $q(t_n)$ subcodes. The non-coherent CPM correlator of Fig. 10 should perform no worse as far as cross-correlation than a bi-phase correlator with the same code. In other words, if a given code produces a maximum time sidelobe value of 4/16 through bi-phase correlation, then the worst time sidelobe to be expected from the Fig. 10 correlator should also be 4/16.

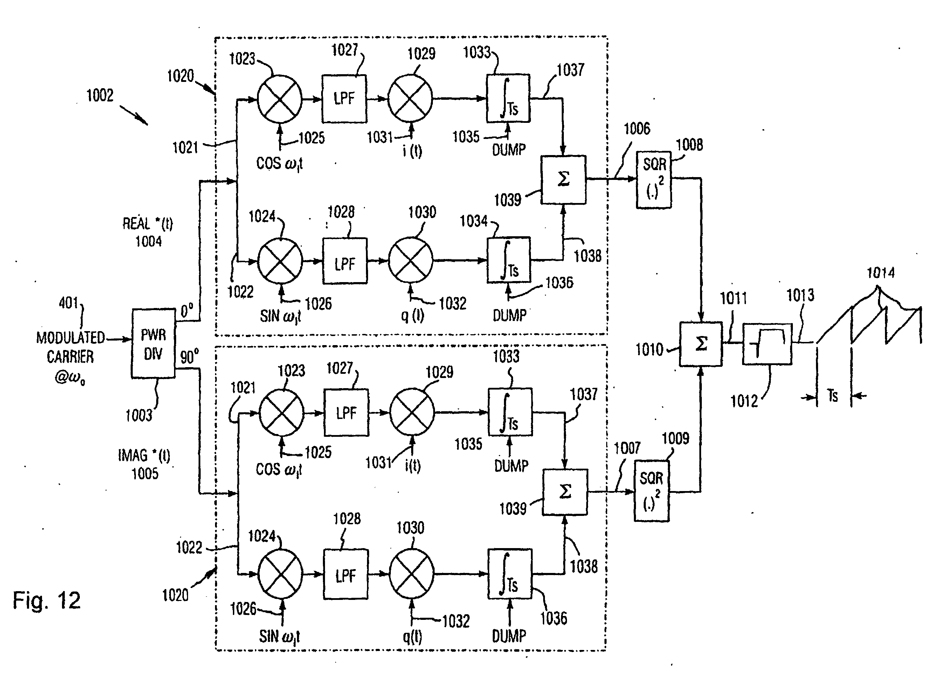

Figure 12 is a block diagram of a non-coherent spread spectrum receiver using serial correlation for separable real and imaginary parts of the received spread spectrum signal.

Conceptually, the non-coherent serial CPM correlator of Fig. 12 operates in a similar fashion as the non-coherent CPM correlator 702 of Fig. 10. The received signal s*(t) 401 is coupled to a non-coherent serial, CPM correlator 1002 for recognizing a chip sequence in the received signal s*(t) 401. The non-coherent serial CPM correlator 1002 comprises a power divider 1003, which produces duplicate signals, Real*(t) 1004 having a 0-degree phase delay, and Imag*(t) 1005 having a 90-degree phase delay. Real*(t) 1004 and Imag*(t) 1005.are the real and imaginary parts of'the received signal s*(t) 401.

The Real*(t) signal 1004 is coupled to a serial CPM correlator 1020 which produces a real correlation signal 1006. The Imag*(t) signal 1005 is similarly coupled to a second serial CPM correlator 1020 which produces an imaginary correlation signal 1007.

Each serial CPM correlator 1020 comprises a power divider (not shown) which receives an input signal and splits it into duplicate signals 1021 and 1022 with a 0-degree phase delay. The signal 1021 is coupled to a first I multiplier 1023. The other input of the first I multiplier 1023 is coupled to a locally generated non-coherent reference signal cos $\omega_1 t = \cos(\omega_0 + \Delta\omega)t + \theta$ as described earlier with reference to Fig. 10. The output of the first I multiplier 1023 is coupled to an I low pass filter 1027, the output of which is coupled to a second I multiplier 1029. The other input of the second I multiplier 1029 is coupled to an i (t) signal 1031, which is the waveform representing the I chip sequence.

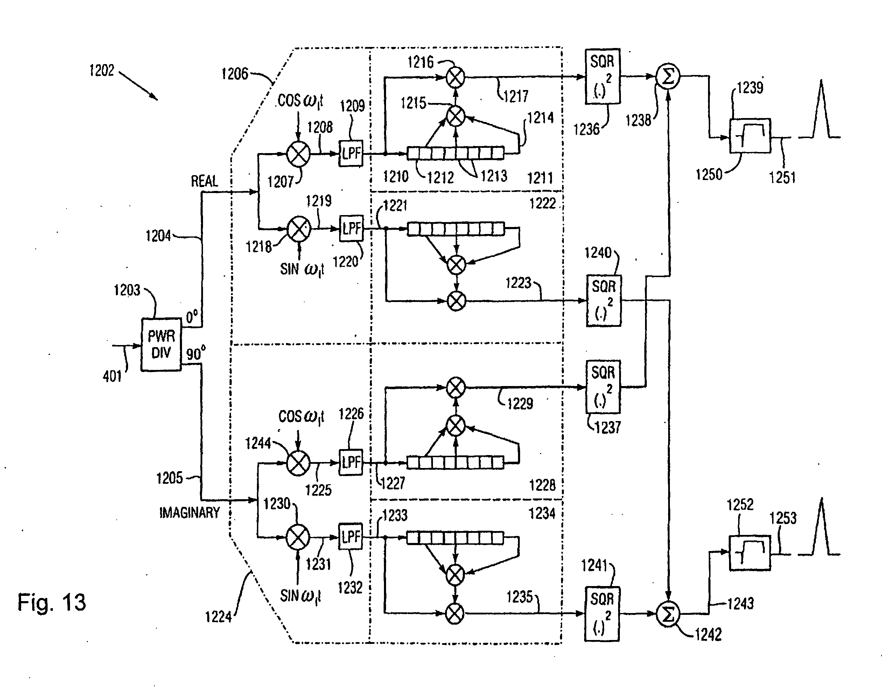

The signal 1022 is coupled to a first Q multiplier 1024. The other input of the first Q multiplier 1024 is coupled to a locally generated non-coherent reference signal sin $\omega_1 t = \sin(\omega_0 + \Delta\omega)t + \theta$ as described earlier with reference to Fig. 10. The output of the first Q multiplier 1024 is coupled to a Q low pass filter 1028, the output of which is coupled to a second Q multiplier 1030. The other input of the second Q multiplier 1030 is coupled to a q(t) signal 1032, which is the waveform representing the Q chip sequence (see Figs. 13A and 13B).

The output of the second I multiplier 1029 is coupled to an I integrator 1033, which integrates its input and dumps the sum under.control of a control input 1035. The I integrator 1033 produces an I correlation signal 1037.

The output of the second Q multiplier 1030 is coupled to a Q integrator 1034, which integrates its input and dumps the sum under control of a control input 1036. The Q integrator 1034 produces a Q correlation signal 1038.

The i(t) signal, which is the waveform representing the I chip sequence, and the q(t) signal, which is the waveform representing the Q chip sequence, each comprise tri-valued return to zero (RZ) waveforms, that is, they are +1 to indicate a logical "1", -1 to indicate a logical "0", and 0 to indicate no value, as shown in Fig. 13B . The i(t) signal and the q(t) signal are offset by one chip time from each other in the sense that the i(t) signal has a value of +1 or -1 at each odd chip time but is 0 during the even chip times, and the q(t) signal has a value of +1 or -1 at each even chip time but is 0 during the odd chip times. Because the i(t) signal and the q(t) signals are tri-valued return to zero waveforms, only one of the integrators 1033, 1034 changes value at a time. The I and Q integrators 1033, 1034 hold their values until instructed to dump.

Synchronization information necessary for controlling the integrate and dump operation of the I and Q integrators 1035, 1036 may be obtained from a parallel correlator receiving timing information from a transmitted preamble in order to generate a correlation pulse. The correlation pulse may be used to control the timing of the serial correlator or correlators. Other suitable methods of control are also possible.

The I correlation signal 1037 and the Q correlation signal 1038 are coupled to a summer 1039, which combines its inputs and produces a unified correlation signal 1006. The unified correlation signal 1006 increases progressively in a stepwise fashion and reaches a maximum when full correlation is achieved. As noted, the CPM correlator 1020 receiving the Real*(t) signal 1004 produces a.real correlation signal 1006, and the second CPM correlator 1020 receiving the Imag*(t) signal 1005 produces an imaginary correlation signal 1007.

The real correlation signal 1006 is coupled to a squaring device 1008, 'which computes the square of its input. The imaginary correlation signal 1007 is coupled to a squaring device 1009, which computes the square of its input. The two squared values are coupled to a summer 1010, which combines its inputs and produces a unified correlation signal 1011 representing the sum of the squares of the real correlation signal 1006 and the imaginary correlation signal 1007. The unified correlation signal 1011 is provided to a square root device 1012 which takes the square root of its input, and generates a final correlation signal 1013. If CSK is used, a maximum correlation pulse 1014 may be achieved once per symbol code time Ts. The squaring of the correlation pulses causes loss of polarity information in the final correlation signal 1013.

Figure 13 shows a block diagram of a first spread spectrum receiver using self-synchronized correlation for separable real and imaginary parts of the received spread spectrum signal.

The received signal s*(t) 401 is coupled to a self-synchronized CPM correlator 1202 for recognizing a correlation sequence in the received signal s*(t) 401. The self-synchronized CPM correlator 1202 comprises a power divider 1203, which produces duplicate signals; Real*(t) 1204 having a 0-degree phase delay, and Imag*(t) 1205 having a 90-degree phase delay. Real*(t) 1204 and Imag*(t) 1205 are the real and imaginary parts of the received signal s*(t) 401.

The Real*(t) signal 1204 is coupled to a real correlator.1206, which divides its input signal by a power divider (not shown) or other suitable means. The real correlator 1206 comprises a real I multiplier 1207, which is also coupled to a local carrier signal cos $\omega_1$t. The real I multiplier combines its inputs and produces a real I product 1208. The real I product 1208 is coupled to a real I low pass filter 1209, which filters its input and produces a filtered real I signal 1210.

The filtered real I signal 1210 is coupled to a real I self-synchronizing correlator 1211, such as a correlator using self-synchronizing techniques described in US 5,761,239.

The real I self-synchronizing correlator 1211 comprises a shift register 1212 having a plurality of chips 1213 and a plurality of taps 1214 coupled to selected chips 1213. The taps 1214 are coupled to a first tap multiplier 1215, which combines its inputs to produce a product which is thereafter coupled to a second tap multiplier 1216. The second tap multiplier 1216 is also coupled to the filtered real I signal 1210. The second tap multiplier 1216 combines its inputs and produces a real I correlation signal 1217.

The real correlator 1206 further comprises a real Q multiplier 1218, which is coupled to a local carrier signal sin $\omega_1$t. The real Q multiplier 1218 combines its inputs and produces a real Q product 1219. The real Q product 1219 is coupled to a real Q low pass filter 1220, which filters its input and produces a filtered real Q signal 1221.

The filtered real Q signal 1221 is coupled to a.real Q self-synchronizing correlator 1222, which produces a real Q correlation signal 1223.

The Imag*(t) signal 1205 is coupled to an imaginary correlator 1224, which divides its input signal by a power divider (not shown) or other suitable means. The imaginary correlator 1224 comprises an imaginary I multiplier 1244, which is also coupled to a local carrier signal cos $w_1$t. The imaginary I multiplier 1244 combines its input and produces an imaginary I product 1225. The imaginary I product 1225 is coupled to an imaginary I low pass filter 1226, which filters its input and produces a filtered imaginary I signal 1227.

The filtered imaginary I signal 1227 is coupled to an imaginary I self-synchronizing correlator 1228, which produces an imaginary I correlation signal 1229.

The imaginary correlator 1224 comprises an imaginary Q multiplier 1230, which is also coupled to a local carrier signal sin $\omega_1$t. The imaginary Q multiplier 1230 combines its inputs and produces an imaginary Q product 1231. The imaginary Q product 1231 is coupled to an imaginary Q low pass filter 1232, which filters its input and produces a filtered imaginary Q signal 1233.

The filtered imaginary Q signal 1233. is coupled to an imaginary Q self-synchronizing correlator 1234, which produces an imaginary Q correlation signal 1235.

The real I correlation signal 1217 and the imaginary I correlation signal 1229 are coupled to squaring devices 1236 and 1237 respectively, the outputs of which are coupled to a summer 1238, to produce a unified I correlation signal 1239. The unified I correlation signal 1239 is coupled to a square root device 1250 which takes the square root of its input and generates an final I correlation signal 1251.

The real Q correlation signal 1223 and the imaginary Q correlation signal 1235 are coupled to squaring devices 1240 and 1241 respectively, the outputs of which are coupled to a summer 1242, to produce a unified Q correlation signal 1243. The unified Q correlation signal 1243 is coupled to a square root device 1252 which takes the square root of its input and generates an final Q correlation signal 1253.

Embodiments and other aspects of the inventions described herein, including the system embodiments described below, may be made.or used in conjunction with inventions described, in whole or in part, in the patents, publications, or copending applications referred to herein as well as in US Patent No. 5,455,822 and in US Patent No. 6,088,590.

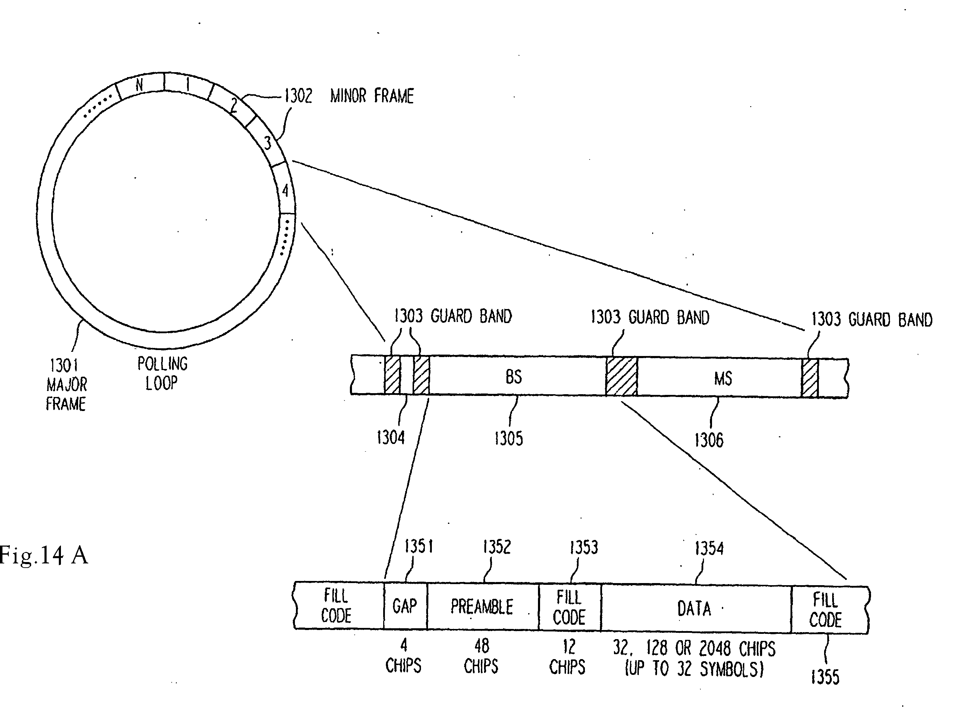

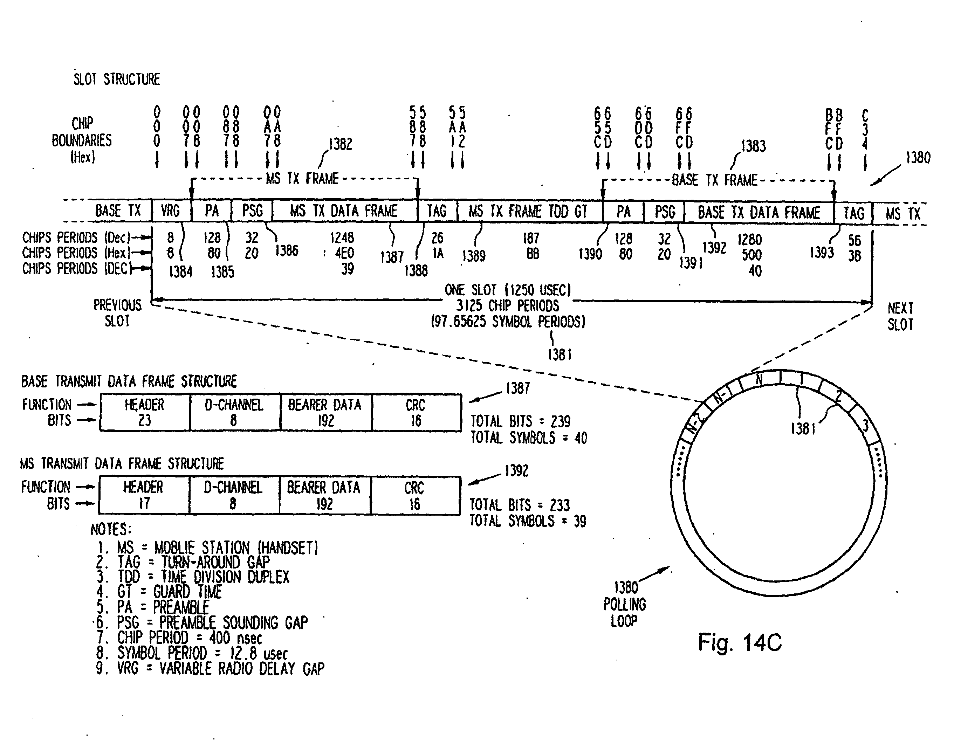

A preferred communication protocol is depicted in Fig. 14C. As shown in Fig. 14C, a polling loop 1380 ("major frame") comprises a plurality of time slots 1381 ("minor frames"). Each minor frame 1381 preferably comprises communication between a base station (e.g., cellular station) and a user station (e.g., mobile user) in time division duplex -- that is, the base station transmits to a user station and the user station transmits back to the base station within the same minor frame 1381.

More specifically, as shown in an exploded view in Fig. 14C, a minor frame 1381 preferably comprises a mobile or user transmission 1382 preceding a base transmission 1383. The minor frame 1381 also comprises a variable radio delay gap 1384 preceding the user transmission 1382, followed by a turn-around gap 1388 and a guard time gap 1389. After gap 1389 is the base transmission 1383, which is followed by another turn-around gap 1393. The user transmission 1382 comprises a preamble 1385, a preamble sounding gap 1386, and a user message interval 1387. The base transmission comprises a preamble 1390, a preamble sounding gap 1391, and a base message interval 1392.

Another communication protocol is shown in Fig. 14A. In the particular protocol of Fig. 14A, a polling loop 1301 ("major frame") comprises a plurality of time slots 1302 ("minor frames"). Each minor frame 1302 comprises communication between a base station (e.g., cellular station) and a user station (e.g., mobile user) in time division duplex -- that is, the base station transmits to a user station and the user station transmits back to the base station within the same minor frame 1302.

More specifically, as shown in an exploded view in Fig. 14A, a minor frame 1302 comprises a power control pulse transmission 1304 from the user station to the base station, a base station transmission 1305, and a user station transmission 1306, each of which is surrounded by guard bands 1303. Details regarding the power control pulse transmission 1304 may be found in US Patent No. 6,088,590, filed August 1, 1994.

The base station transmission 1305 and the user station transmission 1306 have a similar structure; thus, the following description regarding the base station transmission 1305 applies equally to the user station transmission 1306.

The base station transmission 1305 comprises an interframe gap 1351, a matched filter code 1352, a first fill code 1353, a data sequence 1354, and a second fill code 1355 similar to the first fill code 1353. The interframe gap 1351 may be four chips in duration; the matched filter code 1352 may be 48 chips duration; the first fill code 1353 may be 16 chips in duration; the data sequence 1354 may be comprised of one or more symbol codes, each of which may be 32 chips, 128 chips, 2048 chips, or some other number of chips in duration depending upon a data rate for transmission between the base station and the user station; and the second fill code 1355 may be a sufficient number of chips in duration to complete the minor frame 1302. A plurality of minor frames 1302 may comprise a channel.

The fill codes 1353, 1355 preferably each comprise a code that has a low cross-correlation with each of the symbol codes, and may form a repeated pattern such as "0 1 0 1 ..." or "0 0 1 1 ...." The interframe gap 1351 may have the same code as one or both of the fill codes 1353, 1355. Fill codes 1353, 1355 are generated primarily for the purpose of starting the modulator in a known state at the beginning of a transmission, and to avoid having to turn the transmitter off and on for the time period while the fill code 1305 is transmitted. The fill codes 1353, 1355 may further be selected to improve the spectral characteristics of the overall transmission.

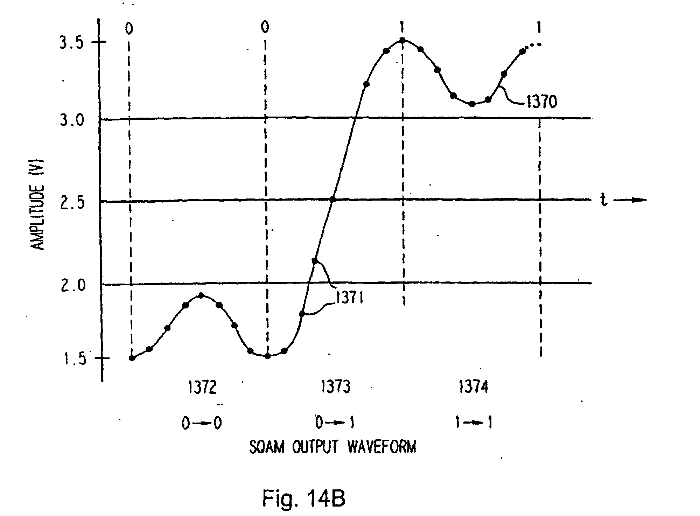

An example of an output SQAM waveform 1370 is shown in Fig. 14B. The waveform 1370 comprises a 0/0 transition 1372, a 0/1 transition 1373, and a 1/1 transition 1374. Each transition 1372, 1373, 1374 comprises eight discrete points 1371 corresponding to values selected by the 4-15 I lookup table 1332 (or Q lookup table 1334). The effect of the low pass filter (not shown) at the output of a waveform generator smooths the shape of the waveform 1370 between discrete points 1371.

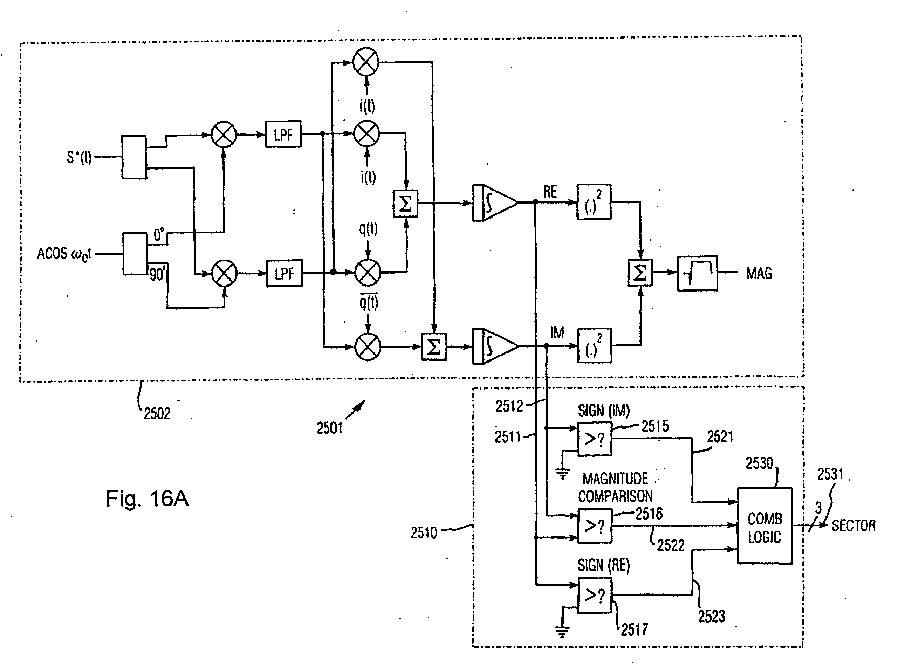

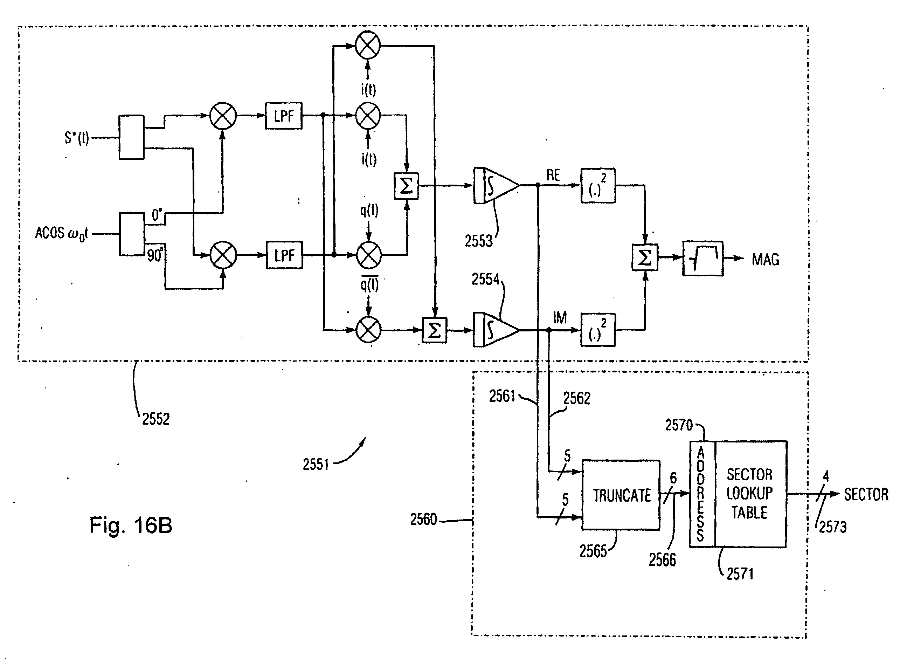

Figures 16A and 16B-16C are block diagrams of two different arrangements of a receiver for recognizing phase information in a received differentially phase encoded CPM signal. In fig. 16A, a receiver 2501 comprises a CPM correlator 2502 which generates a real correlation signal 2511 and an imaginary correlation signal 2512 in response to receiving a phase encoded CPM signal. The CPM correltor 2502 of Fig. 16A may be embodied as any of the CPM correlators of Figs. 10 or 12 according to the invention which generate real and imaginary correlation signals. In the particular embodiment shown in Fig. 16A, a different correlator is used.

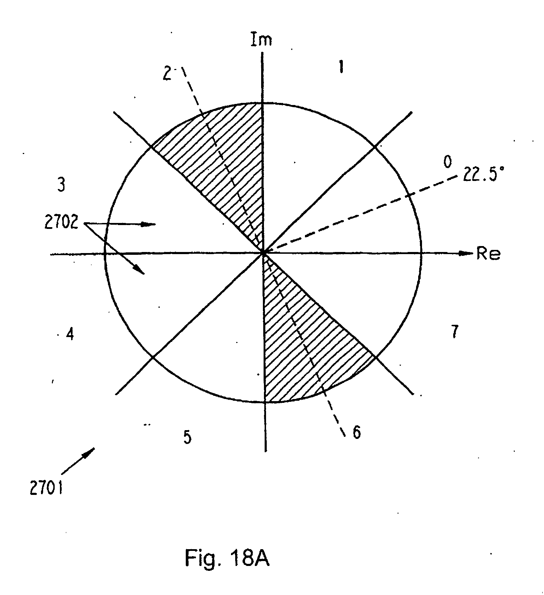

The real correlation signal 2511 and the imaginary correlation signal 2512 are coupled to a phase discriminator 2510 which, in response thereto, determines the phase angle of the received signal. In a preferred embodiment, the phase discriminator 2510 determines not the precise phase angle of the received signal, but only a sector which the phase angle lies within. operation of the phase discriminator 2510 may be explained with reference to Fig. 18A. Figure 18A is a phase angle graph showing a circle 2701 divided into a plurality of sectors 2702. The x-axis of the graph of Fig. 18A corresponds to a real correlation value, while the y-axis of the Fig. 18A graph corresponds to an imaginary correlation value. Assuming a lossless communication channel and a capability of perfect correlation, the real correlation value and imaginary correlation value may be seen as forming coordinates <Re, Im> for each symbol that would lie somewhere on circle 2701. In other words, the total correlation magnitude C for a correlated symbol would always be the same ($Re^2 + Im^2 = C^2$), but the phase angle would vary along the circle 2701 depending on the relative phase difference in the transmitter and receiver clocks.

Because it may be assumed that the communication channel will be subject to losses and noise interference, and that the correlator hardware has practical limitations, the total correlation magnitude C for a correlated symbol may be other than the total correlation value represented by circle 2701. Thus, the real correlation value and imaginary correlation value coordinates <Re, Im> may generally lie anywhere within or even without the circle 2701.

The phase discriminator 2510 determines the phase of the received CPM signal by determining the sign of the real correlation signal 2511 and the sign of the imaginary correlation signal 2512, and by comparing the relative magnitudes of the real correlation signal 2511 and the imaginary correlation signal 2512. Based on the derived information, the phase discriminator 2510 determines the sector 2702 in which the phase angle lies.

In more detail, the real correlation signal 2511 is . compared against zero by comparator 2517, which outputs a real sign signal 2523. The imaginary correlation signal 2312 is compared against zero by comparator 2515, which outputs an imaginary sign signal 2521. The relative magnitudes of the real correlation signal 2511 and the imaginary correlation signal 2512 are compared by a magnitude comparator 2516, which outputs a magnitude comparison signal 2522. The magnitude comparator 2516 and comparators 2515 and 2517 may be either analog or digital, depending upon whether the real correlation signal 2511 and imaginary correlation signal 2512 are analog or digital signals.

The real sign signal 2523, imaginary sign signal 2521, and magnitude comparison signal 2522 are connected to a sector logic block 2530, which outputs a phase sector signal 2531 identifying the sector 2702 of the received phase angle as shown in Fig. 18A. The sectors 2702 in Fig. 18A are arranged as follows. Each sector 2702 covers a 45° region of circle 2701, with each pair of adjacent sectors 2702 defining a quadrant. Thus, sectors 0 and 1 define a first quadrant; sectors 2 and 3 define a second quadrant; sectors 4 and 5 define a third quadrant; and sectors 6 and 7 define a fourth quadrant. The real sign signal 2523 and imaginary sign signal 2521 together determine the quadrant of the phase angle, while the magnitude comparison signal 2522 determines which sector 2702 of the quadrant the phase angle lies in.

Thus, for example, where the sign of the real correlation signal 2511 and the sign of the imaginary correlation signal 2512 are both positive, it may be concluded that the phase angle lies in the quadrant defined by sectors 0 and 1. The magnitude comparison signal 2522 then determines which of sector 0 and 1 the phase angle lies within. If the real correlation signal 2511 (i.e., the first coordinate Re of the <Re, Im> pair) is equal in magnitude to the imaginary correlation signal 2512 (i.e., the second coordinate Im of the <Re, Im> pair), then the phase angle would lie on the 45° border between sectors 0 and 1. If the real correlation signal 2511 is greater in magnitude than the imaginary correlation signal 2512, then the phase angle lies below the 45° border between sectors 0 and 1 and therefore lies in sector 0. Similarly, if the real correlation signal 2511 is smaller in magnitude than the imaginary correlation signal 2512, then the phase angle lies above the 45° border between sectors 0 and 1 and therefore lies in sector 1.

Table 25-1 illustrates the eight possible combinations of real correlation signal sign, imaginary correlation signal sign, and relative magnitude of real and imaginary correlation signals for the sector arrangement of Fig. 18A.

Table 25-1

| Real Sign | Imaginary Sign | Larger Magnitude | Sector |
|-----------|----------------|------------------|--------|
| - | - | Re | 4 |
| - | - | Im | 5 |
| - | + | Re | 3 |
| - | + | Im | 2 |
| + | - | Re | 7 |
| + | - | Im | 6 |
| + | + | Re | 0 |
| + | + | Im | 1 |

Phase logic block 2530 implements Table 25-1, and, in response to its inputs, outputs a three-bit phase sector signal 2531 identifying the sector in which the phase angle lies.

Once the sector of the phase angle is determined, the phase information of the received signal may be decoded by comparing the current phase sector against the previous phase sector. If the current phase sector differs from the previous phase sector by an amount closer to 0° than 180°, then it may be concluded that there was no phase change in the received signal and, therefore, that the phase information encoded in the received signal is a 0-bit. Conversely, if the current phase sector differs from the previous phase sector by an amount closer to 180° than 0°, then it may be concluded that there was a phase inversion in the received signal and, therefore, that the phase information encoded in the received signal is a 1-bit.

The phase sector comparison may be further explained with reference to Fig. 18A. As an example, assume that the previous phase sector was sector 0. In such a case, if the current phase sector is any of sectors 0, 1 or 7, then it may be concluded that there was no phase change in the received signal and, therefore, that the phase information encoded in the received signal is a 0-bit. If, on the other hand, the current phase sector is any of sectors 3, 4 or 5, then it may be concluded that there was a phase inversion in the received signal and, therefore, that the phase information encoded in the received signal is a 1-bit. If, however, the current phase sector is either sector 2 or 6, it cannot necessarily be concluded with sufficient certainty whether or not a phase inversion occurred in the received signal. The reason for this ambiguity is that the phase angle is approximated each symbol period in terms of a 45° sector, and is not measured to a finer degree. Experiment has shown that if the current phase sector falls in either of the sectors at a 90° orientation with respect to the previous phase sector, then treating the situation as one in which there is no phase inversion is preferred. Thus, in the present example, if the current phase sector is either sector 2 or 6, then the phase change should be treated as 0°, and the phase information considered a 0-bit.

More generally, if the current phase sector is positioned within two sectors 2702 of the previous phase sector, then it may be concluded that no phase change has occurred in the received signal. If, on the other hand, the current phase sector.is positioned more than two sectors 2702 away from the previous phase sector, then it may be concluded that a phase inversion has occurred in the received signal.

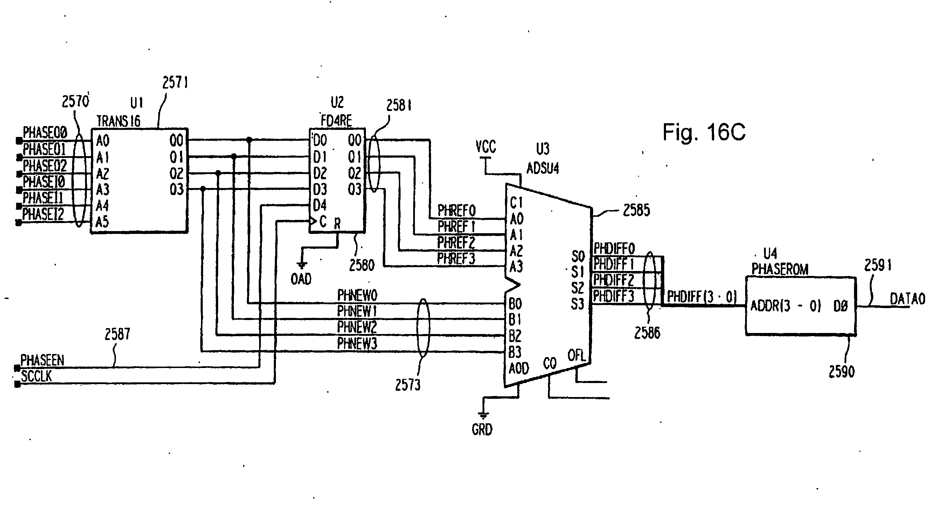

Figures 16B and 16C are block diagrams of an alternative arrangement of a receiver having a phase decoding capability such that phase information in a received differentially phase encoded CPM signal may be recognized. In Fig. 16B,a receiver 2551 comprises a CPM correlator 2552 which generates a real correlation signal 2561 and an imaginary correlation signal 2562 in response to receiving a phase encoded CPM signal. The CPM correlator 2552 of Fig. 25B may be embodied as any of the CPM correlators of Figs. 10 or 12, according to the invention, which generate real and imaginary correlation signals. In the particular embodiment shown in Fig. 16, a different correlator is used.

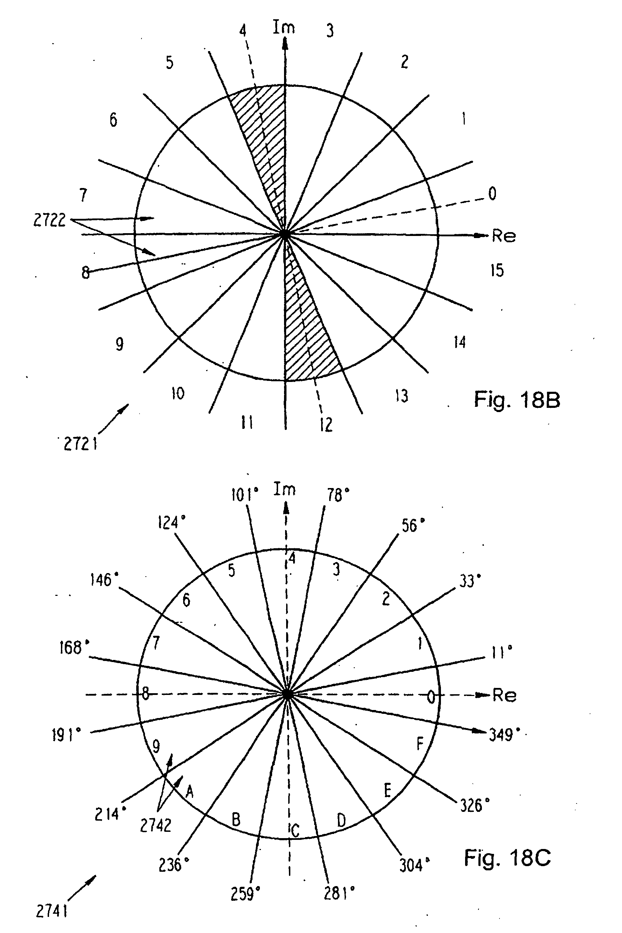

The real correlation signal 2561 and the' imaginary correlation signal 2562 are coupled to a phase discriminator 2560 which, in response thereto, determines the phase angle of the received signal. In a preferred embodiment, the phase discriminator 2560 determines not the precise phase angle of the received signal, but only a sector which the phase angle lies within. Operation of the phase discriminator 2560 may be explained with reference to Fig. 18B. Figure 18Bis a phase map showing a circle 2721 divided into a plurality of sectors 2722, similar to Fig. 18A. Phase discriminator 2560 determines which sector 2722 the phase angle of the received signal lies in, and is therefore functionally similar to phase discriminator 2510 of Fig. 16A.

In a preferred arrangement, the real correlation signal 2561 and imaginary correlation signal 2562 are derived using integrators 2553 and 2554, respectively, wherein integrators 2553 and 2554 each comprise a digital counter. Thus, integrators 2553 and 2554 each output a binary count signal representing a correlation value, such as a 5-bit binary signal. Real correlation signal 2561 and imaginary correlation signal 2562 are each connected to a truncate block 2565, which preferably selects a predefined number of the most significant bits of its inputs.

In a particular arrangement,integrators 2553 and 2554 each comprise digital up-counters, and real correlation signal 2561 and imaginary correlation signal 2562 each comprise a first sign bit followed by four magnitude bits. In this embodiment, a correlation value of thirty-one (binary 11111) represents a maximum positive correlation, a correlation value of fifteen (binary 01111) or sixteen (binary 10000) represents a minimal correlation, and a correlation value of zero (binary 00000) represents a maximum negative correlation. In a preferred arrangement, integrators 2553 and 2554 are embodied as six-bit digital counters so as to reach a maximum positive correlation value of thirty-two (binary 100000) instead of thirty-one.

In the Fig. 16B receiver, truncate block 2565 selects the three most significant bits of the real correlation signal 2561 and the three most significant bits of the imaginary correlation signal 2562. The phase discriminator 2560 uses these truncated correlation values to estimate the phase angle according to the general equation $\phi = \text{Arctan}(\text{Im}/\text{Re})$. Because each truncated correlation value represents a range of correlation values, a median value is chosen for each truncated value for use in the Arctangent calculation. In a preferred embodiment, the median value chosen for each truncated value is selected according to Table 25-2.

Table 25-2

| CORRELATION SCORE (SIGN, 2 MSB's) | VALUE USED FOR ARCTAN CALCULATION | RANGE OVER WHICH TRUNCATED SCORE CAN VARY |
|---|---|---|
| 000 | -14 | -12 → -15 |
| 001 | -10 | -8 → -11 |
| 010 | -6 | -4 → -7 |
| 011 | -2 | 0 → -3 |
| 100 | 2 | 0 → 3 |
| 101 | 6 | 4 → 7 |
| 110 | 10 | 8 → 11 |
| 111 | 14 | 12 → 15 |

By using three bits from the real correlation signal 2561 and three bits from the imaginary correlation signal 2562 to estimate the phase angle, the phase angle is thereby quantized into one of sixty-four possible locations in the phase map of Fig. 27B. The different possible phase angles and resulting sector location may be determined according to Table 25-3 below, wherein "Real" represents the truncated real correlation value, "Imag" represents the truncated imaginary correlation value, "Real Vector Value" is the median real correlation value selected based on the truncated real correlation value according to Table 25-2, "Imag vector Value" is the median imaginary correlation selected based on the truncated imaginary correlation value according to Table 25-2, "Phase" is the phase angle calculated based on an arctangent of the Real Vector Value and the Imag Vector Value, and "Sector" refers to the sector in which the phase angle lies, according to a preferred sector mapping shown in Fig. 18C.

## Table 25-3

| SECTOR MAPPING | | | | | |
|---|---|---|---|---|---|
| REAL VECTOR VALUE | REAL | IMAG VECTOR VALUE | IMAG | SECTOR | PHASE |
| -14 | 000 | -14 | 000 | A | 225 |
| -14 | 000 | -10 | 001 | A | 215 |
| -14 | 000 | -6 | 010 | 9 | 200 |
| -14 | 000 | -2 | 011 | 8 | 188 |
| -14 | 000 | +2 | 100 | 8 | 172 |
| -14 | 000 | +6 | 101 | 7 | 160 |
| -14 | 000 | +10 | 110 | 6 | 145 |
| -14 | 000 | +14 | 111 | 6 | 135 |

| SECTOR MAPPING | | | | | |
|---|---|---|---|---|---|
| REAL VECTOR VALUE | REAL | IMAG VECTOR VALUE | IMAG | SECTOR | PHASE |
| -10 | 001 | -14 | 000 | A | 234 |
| -10 | 001 | -10 | 001 | A | 225 |
| -10 | 001 | -6 | 010 | 9 | 210 |
| -10 | 001 | -2 | 011 | 9 | 191 |
| -10 | 001 | +2 | 100 | 7 | 169 |
| -10 | 001 | +6 | 101 | 7 | 150 |
| -10 | 001 | +10 | 110 | 6 | 135 |
| -10 | 001 | +14 | 111 | 6 | 125 |
| -6 | 010 | -14 | 000 | B | 247 |
| -6 | 010 | -10 | 001 | B | 239 |
| -6 | 010 | -6 | 010 | A | 225 |
| -6 | 010 | -2 | 011 | 9 | 198 |
| -6 | 010 | +2 | 100 | 7 | 162 |
| -6 | 010 | +6 | 101 | 6 | 135 |
| -6 | 010 | +10 | 110 | 5 | 121 |
| -6 | 010 | +14 | 111 | 5 | 113 |
| -2 | 011 | -14 | 000 | C | 262 |
| -2 | 011 | -10 | 001 | C | 259 |
| -2 | 011 | -6 | 010 | B | 251 |

| SECTOR MAPPING | | | | | |
|---|---|---|---|---|---|
| REAL VECTOR VALUE | REAL | IMAG VECTOR VALUE | IMAG | SECTOR | PHASE |
| -2 | 011 | -2 | 011 | A | 225 |
| -2 | 011 | +2 | 100 | 6 | 135 |
| -2 | 011 | +6 | 101 | 5 | 109 |
| -2 | 011 | +10 | 110 | 4 | 101 |
| -2 | 011 | +14 | 111 | 4 | 98 |
| +2 | 100 | -14 | 000 | C | 278 |
| +2 | 100 | -10 | 001 | C | 281 |
| +2 | 100 | -6 | 010 | D | 288 |
| +2 | 100 | -2 | 011 | E | 315 |
| +2 | 100 | +2 | 100 | 2 | 45 |
| +2 | 100 | +6 | 101 | 3 | 72 |
| +2 | 100 | +10 | 110 | 4 | 79 |
| +2 | 100 | +14 | 111 | 4 | 82 |
| +6 | 101 | -14 | 000 | D | 293 |
| +6 | 101 | -10 | 001 | D | 301 |
| +6 | 101 | -6 | 010 | E | 315 |
| +6 | 101 | -2 | 011 | F | 342 |
| +6 | 101 | +2 | 100 | 1 | 18 |
| +6 | 101 | +6 | 101 | 2 | 45 |

| SECTOR MAPPING | | | | | |
|---|---|---|---|---|---|
| REAL VECTOR VALUE | REAL | IMAG VECTOR VALUE | IMAG | SECTOR | PHASE |
| +6 | 101 | +10 | 110 | 3 | 59 |
| +6 | 101 | +14 | 111 | 3 | 67 |
| +10 | 110 | -14 | 000 | E | 305 |
| +10 | 110 | -10 | 001 | E | 315 |
| +10 | 110 | -6 | 010 | F | 329 |
| +10 | 110 | -2 | 011 | F | 349 |
| +10 | 110 | +2 | 100 | 1 | 11 |
| +10 | 110 | +6 | 101 | 1 | 31 |
| +10 | 110 | +10 | 110 | 2 | 45 |
| +10 | 110 | +14 | 111 | 2 | 55 |
| +14 | 111 | -14 | 000 | E | 315 |
| +14 | 111 | -10 | 001 | E | 325 |
| +14 | 111 | -6 | 010 | F | 340 |
| +14 | 111 | -2 | 011 | 0 | 352 |
| +14 | 111 | +2 | 100 | 0 | 8 |
| +14 | 111 | +6 | 101 | 1 | 20 |
| +14 | 111 | +10 | 110 | 2 | 35 |
| +14 | 111 | +14 | 111 | 2 | 45 |

Figure 18C is a diagram of a preferred sector mapping. Figure 18C shows a circle 2741 (similar to the circle 2721 of Fig. 27B) comprising a plurality of sectors 2742. Circle 2741 is divided into sectors 2742 denoted sector 0, 1, 2,...F, according to the mapping set forth in Table 25-4 below.

Table 25-4

| SECTOR DEFINITION | |
|---|---|
| PHASE | SECTOR |
| 349-11 | 0 |
| 11-33 | 1 |
| 33-56 | 2 |
| 56-78 | 3 |
| 78-101 | 4 |
| 101-124 | 5 |
| 124-146 | 6 |
| 146-168 | 7 |
| 168-191 | 8 |
| 191-214 | 9 |
| 214-236 | A |
| 236-259 | B |
| 259-281 | C |
| 281-304 | D |
| 304-326 | E |
| 326-349 | F |

In a preferred arrangement, the sector for the current phase angle is determined by using a six bit signal 2566 comprising the truncated real correlation signal and the truncated imaginary correlation signal as an address 2570 for a sector lookup table 2571. The sector lookup table 2571 may comprise, e.g., a ROM or other non-volatile memory, and outputs a four-bit binary sector signal 2573 indicating which of the sixteen sectors 2742 the phase angle lies in. In a preferred arrangement, the contents of the sector lookup table 2571 are selected according to Table 25-5.

Table 25-5

| SECTOR ROM CONTENTS | |
|---|---|
| ADDRESS (hex) (Re, Im) | DATA (hex) (Sector) |
| 00 | A |
| 01 | A |
| 02 | 9 |
| 03 | 8 |
| 04 | 8 |
| 05 | 7 |
| 06 | 6 |
| 07 | 6 |
| 08 | A |
| 09 | A |
| 0A | 9 |
| 0B | 9 |

| SECTOR ROM CONTENTS | |
|---|---|
| ADDRESS (hex) (Re, Im) | DATA (hex) (Sector) |
| 0C | 7 |
| 0D | 7 |
| 0E | 6 |
| 0F | 6 |
| 10 | B |
| 11 | B |
| 12 | A |
| 13 | 9 |
| 14 | 7 |
| 15 | 6 |
| 16 | 5 |
| 17 | 5 |
| 18 | C |
| 19 | C |
| 1A | B |
| 1B | A |
| 1C | 6 |
| 1D | 5 |
| 1E | 4 |

| SECTOR ROM CONTENTS | |
|---|---|
| ADDRESS (hex)<br>(Re, Im) | DATA (hex)<br>(Sector) |
| 1F | 4 |
| 20 | C |
| 21 | C |
| 22 | D |
| 23 | E |
| 24 | 2 |
| 25 | 3 |
| 26 | 4 |
| 27 | 4 |
| 28 | D |
| 29 | D |
| 2A | E |
| 2B | F |
| 2C | 1 |
| 2D | 2 |
| 2E | 3 |
| 2F | 3 |
| 30 | E |
| 31 | E |

| SECTOR ROM CONTENTS | |
|---|---|
| ADDRESS (hex) (Re, Im) | DATA (hex) (Sector) |
| 32 | F |
| 33 | F |
| 34 | 1 |
| 35 | 1 |
| 36 | 2 |
| 37 | 2 |
| 38 | E |
| 39 | E |
| 3A | F |
| 3B | 0 |
| 3C | 0 |
| 3D | 1 |
| 3E | 2 |
| 3F | 2 |

Once the current sector is determined, the phase information from the received signal may be recognized in a manner similar to that described with respect to Fig. 16A. A preferred embodiment of phase decoding circuitry is shown in Fig. 16C. In Fig. 16B, and in more detail in Fig. 16C, are shown address lines 2570 connected to a sector lookup table 2571, which outputs a sector signal 2573. Figure 16C further shows sector signal 2573 connected to a register 2580, which stores the previous sector value. A previous sector signal 2581 is output from register 2580 and connected to one set of inputs of a subtractor 2585, and sector signal 2573 is connected to another set of inputs of the subtractor 2585. Subtractor 2585 subtracts its inputs and generates a sector difference signal 2586.

The sector difference signal 2586 is used to derive the encoded phase information. If the current phase sector is positioned within four sectors 2742 of the previous phase sector, then it may be concluded that no phase change has occurred in the received signal and, therefore, that the phase information encoded in the received signal is a 0-bit. If, on the other hand, the current.phase sector is positioned more than four sectors 2742 away from the previous phase sector, then it may be concluded that a phase inversion has occurred in the received signal and, therefore, that the phase information encoded in the received signal is a 1-bit. Accordingly, the sector difference signal 2586 is applied as an address to a phase bit lookup table 2590, which outputs a phase bit signal 2591 comprising a 0-bit or a 1-bit depending on the value of the sector difference signal 2586. In a preferred embodiment, the phase bit lookup table 2590 comprises a ROM or other non-volatile memory, the contents of which are in accordance with Table 25-6.

Table 25-6

| PHASE ROM CONTENTS | |
|---|---|
| ADDRESS (hex)<br>(Sector Difference) | DATA (hex)<br>(Nth Bit) |
| 0 | 0 |
| 1 | 0 |
| 2 | 0 |
| 3 | 0 |
| 4 | 0 |
| 5 | 1 |
| 6 | 1 |
| 7 | 1 |
| 8 | 1 |
| 9 | 1 |
| A | 1 |
| B | 1 |
| C | 0 |
| D | 0 |
| E | 0 |
| F | 0 |

It may be noted that the 16-sector receiver of Fig. 18C, like the 8-sector receiver of Fig. 18A, has two sectors 2742 of ambiguity which are aligned at 90° to the previous phase sector. But because there are more sectors 2742 in the Fig. 18C receiver than in the Fig. 18A receiver, and hence a narrower sector size, the regions of ambiguity are reduced in the Fig. 18C receiver. By increasing the number of sectors (which may be done, e.g., by increasing the number of bits used from the correlation signals 2561 and 2562 to calculate the phase angle), the sector size can be further narrowed, so as to further reduce the total region of ambiguity. As with the Fig. 18A receiver, a phase difference falling in a region of ambiguity is preferably treated as indicating no phase inversion -- i.e., the phase information is treated as a 0-bit.

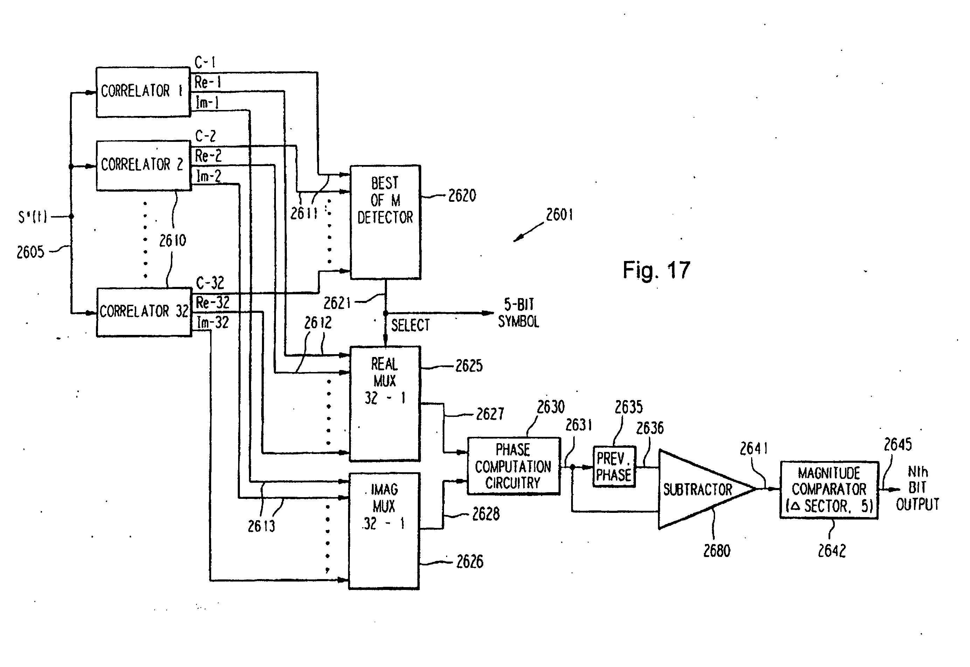

Figure 17 is a block diagram of a preferred receiver for carrying out phase decoding in a 32 symbol transmission technique in accordance with the receiver shown in Figs. 16B and 16C. In Fig. 17, a received signal 2605 is coupled to a plurality of CPM correlators 2610 (e.g., 32 different correlators). Each of the CPM correlators 2610 may be embodied as any of the CPM correlators of Figs. 10 or 12, and each CPM correlator 2610 simultaneously outputs a real correlation signal 2612, an imaginary correlation signal 2613, and a unified correlation signal 2611 in response to receiving the incoming signal 2605.

The correlation signal 2611 from each of the CPM correlators 2610 is coupled to a best-of-M detector 2620, which compares the relative magnitudes of each of the unified correlation signals 2611 and selects the one indicating the highest degree of correlation. The best-of-M detector 2620 outputs a signal 2621 indicating which of the thirty-two symbols has the highest degree of correlation. Signal 2621 is coupled as a select control signal to a real correlation signal multiplexer 2625 and an imaginary correlation signal multiplexer 2626. The real correlation signals 2612 from each of the CPM correlators 2610 are connected as inputs to the real correlation signal multiplexer 2625, and the imaginary correlation signals 2613 from each of the CPM correlators 2610 are connected as inputs to the imaginary correlation signal multiplexer 2626. In response to signal 2621, the real correlation signal 2612 and the imaginary correlation signal 2613 corresponding to the highest correlation symbol are output from the real correlation signal multiplexer 2625 and the imaginary correlation signal multiplexer 2626, respectively, as a selected real correlation signal 2627 and a selected imaginary correlation signal 2628.

The selected real correlation signal 2627 and the selected imaginary correlation signal 2628 are connected to a phase computation block 2630. The phase computation block 2630 outputs a phase estimate signal 2631 which is connected to a previous phase estimate memory 2635 and a subtractor 2640. The subtractor 2640 calculates a difference between the phase estimate signal 2631 and a previous phase estimate signal 2636 stored in the previous phase estimate memory 2635, and derives a phase difference signal 2641 thereby. The phase difference signal 2641 is connected to a magnitude comparator 2642 which determines in response thereto the phase encoded information. The phase computation block 2630, previous phase estimate memory 2635, subtractor 2640, and magnitude comparator 2624 may generally be embodied as sector lookup table 2571, register 2580, subtractor 2585, and phase bit lookup table 2590 appearing in Fig. 16C.

The techniques described above with respect to single bit or biphase encoding may be applied to other levels of encoding, such as, e.g., triphase, quadraphase or octiphase encoding. In quadraphase encoding, for example, two bits of the data signal in the transmitter are used for phase encoding. For each symbol, the phase may be in any one of four relative states, each at 90° with respect to the previous phase state. The phase angle may be determined previously described with respect to Figs. 16A-16C. Depending upon the relative phase difference as reflected in the current and previous sector values, one of four phase states may be derived, and two bits of phase information data recovered in response to the selected one of four phase states.

Alternative Embodiments

While preferred embodiments are disclosed herein, many variations are possible which remain within the scope of the invention, and these variations would become clear to one of ordinary skill in the art after perusal of the specification, drawings and claims herein.

Also, while information to be transmitted from transmitter to receiver is generally referred to herein as "data", the term "data" may comprise data, error-correcting codes, control information, protocol information, or other signals, and all these are deemed to be within the scope of the invention.

While the invention as shown in embodiments herein uses certain CPM encoding techniques, those skilled in the art would recognize, after perusal of this application, that a number of encoding methods, such as MSK, GMSK, SQAM, SQORC, and other known spread-spectrum techniques, would be workable and fall within the scope of the invention. The invention therefore is not to be restricted except within the scope of the appended claims.

**Claims**

1.   A method of despreading a continuous phase modulated spread spectrum signal, the spread spectrum signal generated from a sequence of odd chips and even chips, the method comprising:

receiving the spread spectrum signal (401);
separating (703; 1003) the spread spectrum signal into a real signal (704; 1004) and an imaginary signal (705; 1005) ;

demodulating (720; 1023) the real signal into an I sequence of elements corresponding to the odd chips;
demodulating (730; 1024) the real signal into a Q sequence of elements corresponding to the even chips;
demodulating (740; 1023) the imaginary signal into an I sequence of elements corresponding to the odd chips;
demodulating (742; 1024) the imaginary signal into a Q sequence of elements corresponding to the even chips;
correlating (722; 1029, 1033) the real I sequence with the odd chips to generate a real I correlation signal;
correlating (723; 1030, 1034) the real Q sequence with the even chips to generate a real Q correlation signal;
correlating (724; 1029, 1033) the imaginary I sequence with the odd chips to generate an imaginary I correlation signal;
correlating (725; 1030, 1034) the imaginary Q sequence with the even chips to generate an imaginary Q correlation signal; and
combining (710; 1010) the real I, real Q, imaginary I and imaginary Q correlation signals into a unified correlation signal (711, 1011).

2. The method of Claim 1, wherein:

demodulating the real and imaginary signals into I sequences comprises demodulating the real and imaginary signals with a first local reference signal ($\cos\omega_1 t$) to generate the respective I sequences; and
demodulating the real and imaginary signals into Q sequences comprises demodulating the real and imaginary signals with a second local reference signal ($\sin\omega_1 t$) to generate the respective Q sequences.

3. The method of Claim 1 or 2, wherein combining comprises combining the real I correlation signal and the real Q correlation signal to form a real correlation signal (706), combining the imaginary I correlation signal and the imaginary Q correlation signal to form an imaginary correlation signal (707) and combining (710) the real correlation signal and the imaginary correlation signal into a final correlation signal.

4. The method of any one or more of Claims 1, 2 and 3:
wherein demodulating the real and imaginary signals into I sequences comprises demodulating using a first non-coherent local reference signal ; and
wherein demodulating the real and imaginary signals into Q sequences comprises demodulating using a second non-coherent local reference signal , the second non-coherent local reference signal having the same frequency as the first non-coherent local reference signal but phase offset therefrom by 90 degrees.

5. The method of any one or more of the above claims wherein demodulating the real signal and the imaginary signal further comprises generating a local cosine waveform and a local sine waveform, each of the waveforms having substantially the same frequency ($\omega_1 t$).

6. The method of any one or more of the above claims, wherein:

correlating the real and imaginary I sequences comprises integrating (1033) the respective I sequences to generate respective I correlation signals (1037); and
correlating the real and imaginary Q sequences comprises integrating (1033) the respective Q sequences to generate respective Q correlation signals (1038).

7. The method of any one or more of the above claims:
wherein correlating the real I sequence comprises multiplying (1029) the real I signal with an odd chip signal I(t) representing the odd chips of a chip sequence to generate a real I product signal, integrating (1033) the real I product signal to generate a real I correlation signal (1037);
wherein correlating the imaginary I sequence comprises multiplying (1029) the imaginary I signal with the odd chip I(t) signal to generate an imaginary I product signal, and integrating (1033) the imaginary I product signal to generate an imaginary I correlation signal (1037);
wherein correlating the real Q sequence comprises multiplying (1030) the real Q signal (1022) with an even chip signal Q(t) representing the even chips of the chip sequence to generate a real Q product signal, integrating (1034) the real Q product signal to generate a real Q correlation signal (1038);
wherein correlating the imaginary Q-sequence comprises multiplying (1030) the imaginary Q signal with an inverse of the even chip signal to generate an imaginary Q product signal, and integrating (1034) the imaginary Q product signal to generate an imaginary Q correlation signal (1038); and
wherein combining comprises summing (1039) the real I correlation signal and the real Q correlation signal into the real correlation signal (1006), summing (1039) the imaginary I correlation signal and the imaginary Q correlation signal into the imaginary correlation signal (1007); and combining (1010) the real correlation signal and the imaginary correlation signal into a final correlation signal (1011).

8. An apparatus for despreading a received continuous phase modulated spread spectrum signal (704) comprising:

    a power divider (703; 1003) for dividing a received spread spectrum signal (401) into a real signal (704; 1004) and an imaginary signal (705; 1005);

    a real power divider for dividing the real signal (704; 1004) into a first real signal and a second real signal, the first real signal and the second real signal being duplicates of one another;

    means (720; 1023) for demodulating the first real signal with a first non-coherent local reference signal to generate a real I signal;

    means (730; 1024) for demodulating the second real signal with a second non-coherent local reference signal to generate a real Q signal, the second non-coherent local reference signal phase offset from the first non-coherent local reference signal by 90 degrees;

    a first correlator (715; 1033,1034) for correlating the real I signal and correlating the real Q signal and generating a real correlation signal (707);

    an imaginary power divider for dividing the imaginary signal into a first imaginary signal and a second imaginary signal, the first and the second imaginary signals being duplicates of one another;

    means (740; 1023) for demodulating the first imaginary signal with the first non-coherent local reference signal to generate an imaginary I signal;

    means (742; 1024) for demodulating the second imaginary signal with the second non-coherent local reference signal to generate an imaginary Q signal;

    a second correlator (715; 1033, 1034) for correlating the imaginary I signal and correlating the imaginary Q signal and generating an imaginary correlation signal (707); and

    means (710; 1010) for combining the real correlation signal and the imaginary correlation signal.

9. The apparatus of claim 8 wherein the means (710; 1010) for combining comprises a means (707, 708, 710; 1008, 1009, 1010, 1012) for computing a root of a sum of a square of the real correlation signal and a square of the imaginary correlation signal.

10. The apparatus of claim 8 or 9 wherein the first correlator and the second correlator each comprise:

    an I multiplier (1029) for multiplying the I signal with an odd chip signal representing the odd chips of a chip sequence and for generating an I product signal;

    a Q multiplier (1030) for multiplying the Q signal either with an even chip signal representing the even chips of the chip sequence for the first correlator or with an inverse of the even chips for the second correlator, and for generating a Q product signal;

    an I integrator (1033) for integrating the I product signal and generating an I correlation signal; and

    a Q integrator (1034) for integrating the Q product signal and generating a Q correlation signal.

11. The apparatus of claim 10 wherein the odd chip signal and the even chip signal each comprises a tri-valued return-to-zero waveform.

12. The apparatus of claim 10 or 11 wherein the first and second correlators each further comprises a summer for combining the I correlation-signal and the Q correlation signal into the correlation signal.

13. The apparatus of claim 8 or 9 wherein the first correlator comprises:

an I correlator having a register (726) with a plurality of sequential chip locations for receiving an I signal, a plurality of multipliers (716) for comparing alternating ones of chip locations with odd chips and generating a plurality of comparison values, and an I summer for combining the comparison values; and
a Q correlator having a register (727) with a plurality of sequential chip locations for receiving the Q signal, a plurality of multipliers (716) for comparing alternating ones of chip locations with even chips and generating a plurality of comparison values, and a Q summer for combining the comparison values.

14. The apparatus of any one or more of claims 8 to 13 wherein the first and second correlators comprise first and second continuous phase modulation correlators.

15. A spread-spectrum receiver comprising an apparatus for despreading a received continuous phase modulated spread spectrum signal according to any one of claims 8 to 14.

**Patentansprüche**

1. Verfahren zum Entspreizen eines stetigen, phasenmodulierten Spreizspektrumsignals, welches aus einer Folge von ungeraden und geraden Chips besteht, umfassend die Schritte:

Empfangen des Spreizspektrumsignals (401);

Separieren (703; 1003) des Spreizspektrumsignals in ein Realteilsignal (704; 1004) und ein Imaginärteilsignal (705; 1005);

Demodulieren (720; 1023) des Realteilsignals zu einer I-Folge von Elementen entsprechend den ungeraden Chips;

Demodulieren (730; 1024) des Realteilsignals in eine Q-Folge von Elementen entsprechend den geraden Chips;

Demodulieren (740; 1023) des Imaginärteilsignals in eine I-Folge von Elementen entsprechend den ungeraden Chips;

Demodulieren (742; 1024) des Imaginärteilsignals in eine Q-Folge von Elementen entsprechend den geraden Chips;

Korrelieren (722; 1029, 1033) der realen I-Folge mit den ungeraden Chips, um ein reales I-Korrelationssignal zu erzeugen;

Korrelieren (723; 1030, 1034) der realen Q-Folge mit den geraden Chips, um ein reales Q-Korrelationssignal zu erzeugen;

Korrelieren (724; 1029, 1033) der imaginären I-Folge mit den ungeraden Chips, um ein imaginäres I-Korrelationssignal zu erzeugen;

Korrelieren (725; 1030, 1034) der imaginären Q-Folge mit geraden Chips, um ein imaginäres Q-Korrelationssignal zu erzeugen; und

Kombinieren (710; 1010) des realen I-, des realen Q-, des imaginären I- und des imaginären Q-Korrelationssignals zu einem vereinigten Korrelationssignal (711; 1011).

2. Verfahren nach Anspruch 1, bei dem das Demodulieren der Realteil- und Imaginärteilsignale in I-Folgen das Demodulieren der Realteil- und Imaginärteilsignale mit einem ersten lokalen Referenzsignal ($\cos\omega_1 t$) zum Generieren der jeweiligen I-Folgen umfaßt; und
das Modulieren der Real- und Imaginärteilsignale zu Q-Folgen das Demodulieren der Realteil- und Imaginärteilsignale mit einem zweiten lokalen Referenzsignal ($\sin\omega_1 t$) zum Erzeugen der jeweiligen Q-Folgen umfaßt.

3. Verfahren nach Anspruch 1 oder 2, bei dem das Kombinieren das Kombinieren des realen I-Korrelationssignats und des realen Q-Korrelationssignals zur Bildung eines realen Korrelationssignals (706), das Kombinieren des imaginären I-Korrelationssignals und des imaginären Q-Korrelationssignals zum Bilden eines imaginären Korrelationssignals (707) und das Kombinieren (710) des realen Korrelationssignals und des imaginären Korrelationssignals zu einem endgültigen Korrelationssignal umfaßt.

4. Verfahren nach mindestens einem der Ansprüche 1, 2 und 3, bei dem
das Demodulieren der Realteil- und Imaginärteilsignale zu I-Folgen das Demodulieren unter Verwendung eines ersten nicht-kohärenten lokalen Referenzsignals beinhaltet, und bei dem
das Demodulieren der Realteil- und Imaginärteilsignale zu Q-Folgen das Demodulieren unter Verwenden eines zweiten, nicht-kohärenten lokalen Referenzsignals beinhaltet, wobei das zweite, nicht-kohärente lokale Referenzsignal die gleiche Frequenz wie das erste nicht-kohärente lokale Referenzsignal besitzt, gegenüber diesem aber in der Phase um 90 Grad verschoben ist.

5. Verfahren nach mindestens einem der obigen Ansprüche, bei dem das Modulieren des Realteilsignals und des Imaginärteilsignals weiterhin das Erzeugen einer lokalen Cosinuswellenform und einer lokalen Sinuswellenform beinhaltet, von denen jede Wellenform im wesentlichen die gleiche Frequenz ($\omega_1 t$) aufweist.

6. Verfahren nach mindestens einem der obigen Ansprüche, bei dem
das Korrelieren der realen und imaginären I-Folgen das Integrieren (1033) der jeweiligen I-Folgen zum Erzeugen zugehöriger I-Korrelationssignale (1037) umfaßt, und
das Korrelieren der realen und imaginären Q-Folgen das Integrieren (1033) der jeweiligen Q-Falgen zum Erzeugen zugehöriger Q-Korrelationssignale (1038) umfaßt.

7. Verfahren nach mindestens einem der obigen Ansprüche:

bei dem das Korrelieren der realen I-Folge das Multiplizieren (1029) des realen I-Signals mit einem ungeraden Chip-Signal I(t), welches die ungeraden Chips einer Chipfolge repräsentiert, umfaßt, um ein reales I-Produktsignal zu erzeugen, außerdem das Integrieren (1033) des realen I-Produktsignals, um ein reales I-Korrelationssignal (1037) zu bilden;

bei dem das Korrelieren der imaginären I-Folge das Multiplizieren (1029) des imaginären I-Signals mit dem ungeraden Chip-Signal I(t) zum Erzeugen eines imaginären I-Produktsignals und das Integrieren (1033) des imaginären I-Produktsignals zum Erzeugen eines imaginären I-Korrelationssignal (1037) umfaßt;

bei dem das Korrelieren der realen Q-Folge das Multiplizieren (1030) des realen Q-Signals (1022) mit einem geraden Chip-Signal Q(t), welches die geraden Chips der Chipfolge repräsentiert, umfaßt, um ein reales Q-Produktsignal zu erzeugen, außerdem das integrieren (1034) des realen Q-Produktsignals, um ein reales Q-Korrelationssignal (1038) zu erzeugen;

bei dem das Korrelieren der imaginären Q-Folge das Multiplizieren (1030) des imaginären Q-Signals mit einem Inversen des geraden Chip-Signals zum Erzeugen eines imaginären Q-Produktsignals und das Integrieren (1034) des imaginären Q-Produktsignals zum Erzeugen eines imaginären Q-Korrelationssignals (1038) umfaßt; und

bei dem das Kombinieren das Summieren (1039) des realen I-Korrelationssignals und des realen Q-Korrelationssignals zu dem realen Korrelationssignal (1006), das Summieren (1039) des imaginären I-Korrelationssignals und des imaginären Q-Korrelationssignals zu dem imaginären Korrelationssignal (1007) und das Kombinieren (1010) des realen Korrelationssignals und des imaginären Korrelationssignals zu einem endgültigen Korrelationssignal (1011) umfaßt.

8. Vorrichtung zum Entspreizen eines empfangenen stetigen, phasenmodulierten Spreizspektrumsignals (704), umfassend:

einen Leistungsteiler (703; 1003) zum Teilen eines empfangenen Spreizspektrumsignals (401) in ein Realteilsignal (704; 1004) und ein Imaginärteilsignal (705; 1005);

einen Real-Leistungsteiler zum Teilen des Realteilsignals (704; 1004) in ein erstes Realteilsignal und ein zweites Realteilsignal, die Duplikate voneinander sind;

eine Einrichtung (720; 1023) zum Demodulieren des ersten Realteilsignals mit einem zweiten nicht-kohärenten lokalen Referenzsignal, um ein reales I-Signal zu erzeugen;

eine Einrichtung (730; 1024) zum Demodulieren des zweiten Realteilsignals mit Hilfe eines zweiten nicht-kohärenten lokalen Referenzsignals, um ein reales Q-Signal zu erzeugen, wobei das zweite nicht-kohärente lokale Referenzsignal gegenüber dem ersten nicht-kohärenten lokalen Referenzsignal in der Phase um 90 Grad verschoben ist;

einen ersten Korrelator (715; 1033, 1034) zum Korrelieren des realen I-Signals und zum Korrelieren des realen Q-Signals und zum Erzeugen eines realen Korrelationssignals (707);

einen Imaginär-Leistungsteiler zum Teilen des Imaginärteilsignals in ein erstes Imaginärteilsignal und ein zweites Imaginärteilsignal, die Duplikate voneinander sind;

eine Einrichtung (740; 1023) zum Demodulieren des ersten Imaginärteilsignals mit dem ersten nicht-kohärenten lokalen Referenzsignal, um ein imaginäres I-Signal zu erzeugen;

eine Einrichtung (742; 1024) zum Demodulieren des zweiten Imaginärteilsignals mit dem zweiten, nicht-kohärenten lokalen Referenzsignal, um ein imaginäres Q-Signal zu erzeugen;

einen zweiten Korrelator (715; 1033, 1034) zum Korrelieren des imaginären I-Signals und zum Korrelieren des imaginären Q-Signals und zum Erzeugen eines imaginären Korrelationssignals (707); und

eine Einrichtung (710; 1010) zum Kombinieren des realen Korrelationssignals und des imaginären Korrelationssignals.

9. Vorrichtung nach Anspruch 8, bei der die Elnrichtung (710; 1010) zum Kombinieren einer Einrichtung (707, 708, 710; 1008, 1009, 1010, 1012) zum Berechnen der Wurzel einer Summe eines Quadrats des realen Korrelationssignals und eines Quadrats des imaginären Korrelationssignals aufweist.

10. Vorrichtung nach Anspruch 8 oder 9, bei der der ersten Korrelator und der zweite Korrelator jeweils aufweisen:

einen I-Multiplizierer (1029) zum Multiplizieren des I-Signals mit einem ungeraden Chip-Signal, welches die ungeraden Chips einer Chipfolge repräsentiert, und zum Erzeugen eines I-Produktsignals;

einen Q-Multiplizierer (1030) zum Multiplizieren des Q-Signals entweder mit einem geraden Chip-Signal, welches die geraden Chips der Chipfolge für den ersten Korrelator repräsentiert, oder mit dem Inversen der geraden Chips für den zweiten Korrelator, um ein Q-Produktsignal zu erzeugen;

einen I-Integrator (1033) zum Integrieren des I-Produktsignals und zum Erzeugen eines I-Korrelationssignals; und

einen Q-Integrator (1034) zum integrieren des Q-Produktsignals und zum Erzeugen eines Q-Korrelationssignals.

11. Vorrichtung nach Anspruch 10, bei der das ungerade Chip-Signal und das gerade Chip-Signal jeweils eine dreiwertige RZ-Wellenform aufweisen.

12. Vorrichtung nach Anspruch 10 oder 11, bei der der erste und der zweite Korrelator jeweils außerdem einen Summierer zum Kombinieren des I-Korrelationssignals und des Q-Korrelationssignals zu dem Korrelationssignal aufweisen.

13. Vorrichtung nach Anspruch 8 oder 9, bei dem der erste Korrelator aufweist:

einen I-Korrelator mit einem Register (726) mit einer Mehrzahl sequentieller Chipstellen zum Empfangen eines I-Signals, mit einer Mehrzahl von Multiplizierern (716) zum Vergleichen alternierender Chipstellen mit ungeraden Chips und zum Erzeugen einer Mehrzahl von Vergleichswerten, und mit einem I-Summierer zum Kombinieren der Vergleichswerte; und

einen Q-Korrelator mit einem Register (727) mit einer Mehrzahl sequentieller Chipstellen zum Aufnehmen des Q-Signals, mit einer Mehrzahl von Multiplizierern (716) zum Vergleichen alternativer Chipstellen mit geraden Chips und zum Erzeugen einer Mehrzahl von Vergleichswerten, und mit einem Q-Summierer zum Kombinieren der Vergleichswerte.

14. Vorrichtung nach mindestens einem der Ansprüche 8 bis 13, bei der der erste und der zweite Korrelator einen ersten und einen zweiten kontinuierlichen Phasenmodulationskorrelator aufweisen.

15. Spreizspektrumempfänger, umfassend eine Vorrichtung zum Entspreizen eines empfangenen kontinuierlichen, phasenmodulierten Spreizspektrumsignals nach einem der Ansprüche 8 bis 14.

**Revendications**

1. Procédé de désétalement d'un signal à étalement de spectre et à modulation, à phase constante, le signal à étalement de spectre étant généré à partir d'une séquence de puces à parité impaire et de puces à parité paire, le procédé comprenant les opérations consistant à :

recevoir le signal à étalement de spectre (401) ;
séparer (703 ; 1003) le signal à étalement du spectre en un signal réel (704 ; 1004) et un signal imaginaire (705; 1005) ;
démoduler (720 ; 1023) le signal réel en une séquence I d'éléments correspondant aux puces à parité impaire ;
démoduler (730 ; 1024) le signal réel en une séquence Q d'éléments correspondant aux puces à parité paire ;
démoduler (740 ; 1023) le signal imaginaire en une séquence I d'éléments correspondant aux puces à parité impaire ;
démoduler (742 ; 1024) le signal imaginaire en une séquence Q d'éléments correspondant aux puces à parité paire ;
mettre en corrélation (722 ; 1029, 1033) la séquence I réelle avec les puces à parité impaire afin de générer un signal de corrélation I réel ;
mettre en corrélation (723 ; 1030, 1034) la séquence Q réelle avec les puces à parité paire afin de générer un signal de corrélation Q réel ;
mettre en corrélation (724 ; 1029, 1033) la séquence I imaginaire avec les puces à parité impaire afin de générer un signal de corrélation I imaginaire ;
mettre en corrélation (725 ; 1030, 1034) la séquence Q imaginaire avec les puces à parité paire afin de générer un signal de corrélation Q imaginaire et
combiner (710 ; 1010) les signaux de corrélation I réel, Q réel, I imaginaire et Q imaginaire en un signal de corrélation unifié (711 ; 1011).

2. Procédé selon la revendication 1, dans lequel :

la démodulation des signaux réel et imaginaire en des séquences I comprend la démodulation des signaux réel et imaginaire avec un premier signal local de référence ($\cos\omega_1 t$) afin de générer les séquences I respectives et
la démodulation des signaux réel et imaginaire en séquences Q comprend la démodulation des signaux réel et imaginaire avec un deuxième signal local de référence ($\sin\omega_1 t$) afin de générer les séquences Q respectives.

3. Procédé selon la revendication 1 ou 2, dans lequel la combinaison comprend la combinaison du signal de corrélation I réel et du signal de corrélation Q réel afin de former un signal de corrélation réel (706), la combinaison du signal de corrélation I imaginaire et du signal de corrélation Q imaginaire afin de former un signal de corrélation imaginaire (707) et la combinaison (710) du signal de corrélation réel et du signal de corrélation imaginaire en un signal de corrélation final.

4. Procédé selon l'une quelconque ou plusieurs des revendications 1, 2 et 3 :
dans lequel la démodulation des signaux réel et imaginaire en séquences I comprend une démodulation utilisant un premier signal de référence local non cohérent et

dans lequel la démodulation des signaux réel et imaginaire en séquences Q comprend une démodulation utilisant un deuxième signal local de référence non cohérent, le deuxième signal local de référence non cohérent ayant la même fréquence que le premier signal local de référence non cohérent mais un déphasage par rapport à celui-ci de 90 degrés.

5. Procédé selon l'une quelconque ou plusieurs des revendications ci-dessus, dans lequel la démodulation du signal réel et du signal imaginaire comprend en outre la génération d'une forme d'onde locale en cosinus et une forme d'onde locale lusius, chacune des formes d'ondes ayant sensiblement la même fréquence ($\omega_1 t$).

6. Procédé selon l'une quelconque ou plusieurs des revendications ci-dessus, dans lequel :

   la corrélation des séquences I réelle et imaginaire comprend l'intégration (1033) des séquences I respectives afin de générer des signaux de corrélation I respectifs (1037) et
   la corrélation des séquences Q réelle et imaginaire comprend l'intégration (1033) des séquences Q respectives afin de générer des signaux de corrélation Q respectifs (1038).

7. Procédé selon l'une quelconque ou plusieurs des revendications ci-dessus :
   dans lequel la corrélation de la séquence I réelle comprend la multiplication (1029) du signal I réel par un signal de puce à parité impaire I(t) représentant les puces à parité impaire d'une séquence de puces afin de générer un signal de produit I réel et l'intégration (1033) du signal de produit I réel afin de générer un signal de corrélation I réel (1037) ;
   dans lequel la corrélation de la séquence I imaginaire comprend la multiplication (1029) du signal I imaginaire par le signal de puce à parité impaire I(t) afin de générer un signal de produit I imaginaire et l'intégration (1033) du signal de produit I imaginaire afin de générer un signal de corrélation I imaginaire (1037) ;
   dans lequel la corrélation de la séquence Q réelle comprend la multiplication (1030) du signal Q réel (1022) par un signal de puce à parité paire Q(t) représentant les puces à parité paire de la séquence de puces afin de générer un signal de produit Q réel et l'intégration (1034) du signal de produit Q réel afin de générer un signal de corrélation Q réel (1038) ;
   dans lequel la corrélation de la séquence Q imaginaire comprend la multiplication (1030) du signal Q imaginaire par un inverse du signal de puce à parité paire afin de générer un signal de produit Q imaginaire et l'intégration (1034) du signal de produit Q imaginaire afin de générer un signal de corrélation Q imaginaire (1038) et
   dans lequel la combinaison comprend la sommation (1039) du signal de corrélation I réel et du signal de corrélation Q réel pour obtenir le signal de corrélation réel (1006), la sommation (1039) du signal de corrélation I imaginaire et du signal de corrélation Q imaginaire pour obtenir le signal de corrélation imaginaire (1007) et la combinaison (1010) du signal de corrélation réel et du signal de corrélation imaginaire pour obtenir un signal de corrélation final (1011).

8. Appareil destiné à désétaler un signal reçu (704) à étalement de spectre et à modulation, à phase constante, comprenant :

   un diviseur de puissance (703 ; 1003) destiné à diviser un signal reçu (401) à étalement de spectre en un signal réel (704 ; 1004) et un signal imaginaire (705 ; 1005) ;
   un diviseur de puissance réelle destiné pour le signal réel (704 ; 1004) en un premier signal réel et un deuxième signal réel, le premier signal réel et le deuxième signal réel étant des doubles l'un de l'autre ;
   des moyens (720 ; 1023) pour démoduler le premier signal réel avec un premier signal local de référence non cohérent afin de générer un signal I réel ;
   des moyens (730 ; 1024) destinés à démoduler le deuxième signal réel avec un deuxième signal local de référence non cohérent afin de générer un signal Q réel, le deuxième signal local de référence non cohérent étant déphasé du premier signal local de référence non cohérent de 90 degrés ;
   un premier corrélateur (715 ; 1033, 1034) destiné à mettre en corrélation le signal I réel et à mettre en corrélation le signal Q réel et à générer un signal de corrélation réel (707) ;
   un diviseur de puissance imaginaire destiné à diviser le signal imaginaire en un premier signal imaginaire et un deuxième signal imaginaire, les premier et deuxième signaux imaginaires étant des doublés l'un de l'autre ;
   des moyens (740 ; 1023) destinés à démoduler le premier signal imaginaire avec le premier signal local de référence non cohérent afin de générer un signal I imaginaire ;
   des moyens (742 ; 1024) destinés à démoduler le deuxième signal imaginaire avec le deuxième signal local de référence non cohérent afin de générer un signal Q imaginaire ;
   un deuxième corrélateur (715 ; 1033, 1034) destiné à mettre en corrélation le signal I imaginaire et à mettre en corrélation le signal Q imaginaire et à générer un signal de corrélation imaginaire (707) ; et

des moyens (710 ; 1010) destinés à combiner le signal de corrélation réel et le signal de corrélation imaginaire.

9. Appareil selon la revendication 8, dans lequel les moyens (710 ; 1010) destinés à la combinaison comprennent des moyens (707, 708, 710 ; 1008, 1009, 1010, 1012) destinés à calculer une racine d'une somme d'un carré du signal de corrélation réel et d'un carré du signal de corrélation imaginaire.

10. Appareil selon la revendication 8 ou 9, dans lequel le premier corrélateur et le deuxième corrélateur comprennent chacun :

un multiplicateur I (1029) destiné à multiplier le signal I par un signal de puce à parité impaire représentant les puces à parité impaire d'une séquence de puces et à générer un signal de produit I ;
un multiplicateur Q (1030) destiné à multiplier le signal Q soit par un signal de puce à parité paire représentant les puces à parité paire de la séquence de puces pour le premier corrélateur, soit par un inverse des puces à parité paire pour le deuxième corrélateur et à générer un signal de produit Q ;
un intégrateur I (1033) destiné à intégrer le signal de produit I et à générer un signal de corrélation I ; et
un intégrateur Q (1034) destiné à intégrer le signal de produit Q et à générer un signal de corrélation Q.

11. Appareil selon la revendication 10, dans lequel le signal de puce à parité impaire et le signal de puce à parité paire comprennent chacun une forme d'onde trivalente, avec retour à zéro.

12. Appareil selon la revendication 10 ou 11, dans lequel les premier et deuxième corrélateurs comprennent chacun en outre un additionneur destiné à combiner le signal de corrélation I et le signal de corrélation Q pour obtenir le signal de corrélation.

13. Appareil selon la revendication 8 ou 9, dans lequel le premier corrélateur comprend :

un corrélateur I ayant un registre (726) avec une pluralité d'emplacements de puces séquentiels destinée à recevoir un signal I, une pluralité de multiplicateurs (716) destinée à comparer des emplacements alternatifs parmi des emplacements de puces avec des puces à parité impaire et à générer une pluralité de valeurs de comparaison et un additionneur I destiné à combiner les valeurs de comparaison ; et un registre (727) avec une un corrélateur Q ayant un registre (727) avec une pluralité d'emplacements de puces séquentiels destinée à recevoir le signal Q, une pluralité de multiplicateurs (716) destinée à comparer des emplacements alternatifs parmi des emplacements de puces avec des puces à parité paire et à générer une pluralité de valeurs de comparaison et un additionneur Q destiné à combiner les valeurs de comparaison.

14. Appareil selon l'une quelconque ou plusieurs des revendications 8 à 13, dans lequel les premier et deuxième corrélateurs comprennent des premier et deuxième corrélateurs à modulation à phase constante.

15. Récepteur de signaux à étalement de spectre comprenant un appareil destiné à désétaler un signal reçu à étalement de spectre à modulation, à phase constante, selon l'une quelconque des revendications 8 à 14.

*103*

*105*

*106*

*108*

*111*

*113*

*102*

PN

*104*

*101*

FIG. 1

(PRIOR ART)

*107*

PN

*110*

*112*

*151*

| | | C 155 | | |
| C 155 | C 155 | | C 155 | |
| | | B 154 | | C 155 |
| C 155 | B 154 | | B 154 | |
| | | A 153 | | C 155 |
| C 155 | B 154 | | B 154 | |
| | | B 154 | | C 155 |
| C 155 | | C 155 | | |
| | | C 155 | C 155 | |

*152*

FIG. 2

*201*

θ(t)

π

π/2

$T_c$    $2T_c$    $3T_c$    $4T_c$

-π/2

-π

FIG. 3

EP 0 806 079 B1

*FIG. 4A*

*FIG. 4B*

*FIG. 4C*

40

FIG. 5A
(Prior Art)

FIG. 5B

FIG. 9

303

$i = C_{n-3}, C_{n-1}, C_{n+1}, C_{n+3}$
RATE = Rc/2

301      302

$C_{n-4}, C_{n-3}, C_{n-2}, C_{n-1},$
$C_n, C_{n+1}, C_{n+2}, C_{n+3}$
RATE = Rc

P(t)

305

307

I

$i(t)\cos(\omega_o(t))$
308

$s(t)$
313

COS $\omega_o t$

$\Sigma$

312

CPM
MODULATED
CARRIER

306

$q = C_{n-4}, C_{n-2}, C_n, C_{n+2}$
RATE = Rc/2

304

P(t)

Q

310

$q(t)\sin(\omega_o(t))$
311

SIN $\omega_o t$

*FIG. 6*

402

406

DELAY

407

408

Tc

I CORRELATOR

CHIP RATE = Rc/2

412

401

CPM
MODULATED
CARRIER

CHIP RATE = Rc

PWR
DIV

0°

$i^*(t)$
404

90°

411

$\Sigma$

403

410

$q^*(t)$
405

Q CORRELATOR

CHIP RATE = Rc/2

409

*FIG. 7*

FIG. 8

CSK SYMBOL TIME

EP 0 806 079 B1

FIG. 10

780

i(t)

**FIG. 11A**

1   1   1   1   0   1   0   1   1   0   0   1   0   0   0   0

q(t)

**FIG. 11B**

781

$1 \, y_{16} \, y_{15} \cdots$      $\cdots \, y_2 \quad y_1 \quad y_0$

y(t)   0

$q_7 \, | \, i_7 \quad \cdots \cdots$    $q_1 \quad i_1 \quad q_0 \quad i_0$

-1

**FIG. 11C**

$1 \, z_{16} \, z_{15} \cdots$      $\cdots \, z_2 \quad z_1 \quad z_0$

z(t)   0

$q_7 \, | \, i_7 \quad \cdots \cdots$    $q_1 \quad i_1 \quad q_0 \quad i_0$

--1

**FIG. 11D**

1
0.5
0.866...
0.5...

y(t)   0

-0.5    ...-0.5
-1    ...-0.866

**FIG. 11E**

$q_7 \quad i_7 \quad \cdots \cdots$     $\cdots q_1 \quad i_1 \quad q_0 \quad i_0$

1
0.5
0.866...
0.5.

z(t)   0

-0.5
-1    -0.866...    -0.5...

**FIG. 11F**

Fig. 12

Fig. 13

EP 0 806 079 B1

EP 0 806 079 B1

Fig.14 A

1302 MINOR FRAME

1301 MAJOR FRAME

POLLING LOOP

1303 GUARD BAND     1303 GUARD BAND     1303 GUARD BAND

1304    BS    MS

1305    1306

| FILL CODE | GAP | PREAMBLE | FILL CODE | DATA | FILL CODE |
|---|---|---|---|---|---|
| | 1351 | 1352 | 1353 | 1354 | 1355 |
| | 4 CHIPS | 48 CHIPS | 12 CHIPS | 32, 128 OR 2048 CHIPS (UP TO 32 SYMBOLS) | |

Fig. 14B

SLOT STRUCTURE

CHIP BOUNDARIES (Hex)

| BASE TX | VRG | PA | PSG | MS TX DATA FRAME | TAG | MS TX FRAME TDD GT | PA | PSG | BASE TX DATA FRAME | TAG | MS TX |

MS TX FRAME — 1382

BASE TX FRAME — 1383

1380

CHIPS PERIODS (Dec) → 8, 128, 32, 1248, 26, 187, 128, 32, 1280, 56
CHIPS PERIODS (Hex) → 8, 80, 20, 4E0, 1A, BB, 80, 20, 500, 38
CHIPS PERIODS (DEC) →  39, 40

1384 1385 1386 1387 1388 1389 1390 1391 1392 1393

ONE SLOT (1250 USEC)
3125 CHIP PERIODS
(97.65625 SYMBOL PERIODS)
1381

PREVIOUS SLOT

NEXT SLOT

BASE TRANSMIT DATA FRAME STRUCTURE — 1387

| FUNCTION → | HEADER | D-CHANNEL | BEARER DATA | CRC |
| BITS → | 23 | 8 | 192 | 16 |

TOTAL BITS = 239
TOTAL SYMBOLS = 40

MS TRANSMIT DATA FRAME STRUCTURE — 1392

| FUNCTION → | HEADER | D-CHANNEL | BEARER DATA | CRC |
| BITS → | 17 | 8 | 192 | 16 |

TOTAL BITS = 233
TOTAL SYMBOLS = 39

NOTES:
1. MS = MOBLIE STATION (HANDSET)
2. TAG = TURN-AROUND GAP
3. TDD = TIME DIVISION DUPLEX
4. GT = GUARD TIME
5. PA = PREAMBLE
6. PSG = PREAMBLE SOUNDING GAP
7. CHIP PERIOD = 400 nsec
8. SYMBOL PERIOD = 12.8 usec
9. VRG = VARIABLE RADIO DELAY GAP

1380 POLLING LOOP

1381

Fig. 14C

Fig. 15

Fig. 16A

Fig. 16B

Fig. 16C

EP 0 806 079 B1

Fig. 17

EP 0 806 079 B1

Fig. 18A

Fig. 18B

Fig. 18C